# EUROPEAN PATENT APPLICATION

(11) **EP 1 914 439 A2**
(43) Date of publication of application: **23.04.2008**
(21) Application number: 07020224.7
(22) Date of filing: 16.10.2007
(51) Int. Cl.: F16D 65/21

(54) **Electro mechanical brake**

(30) Priority: 16.10.2006 JP 2006280972
(71) Applicant: Hitachi, Ltd., Chiyoda-ku Tokyo 100-8280 (JP)
(72) Inventor: Watanabe, Hirofumi, Chiyoda-ku Tokyo 100-8220 (JP); Suzuki, Takafumi, Chiyoda-ku Tokyo 100-8220 (JP); Yasukawa, Daisuke, Chiyoda-ku Tokyo 100-8220 (JP)
(74) Representative: Beetz & Partner

(57) **Abstract**

When a caliper and an ECU are separately configured in an electro mechanical brake, the number of harness is increased, and therefore, the wiring layout of the harness becomes difficult, and when bending and twisting are applied to the harness, a problem of a breaking of the wiring and the like arises. Further, a voltage drop is caused by the electric resistance of the harness, and moreover, there is a risk of infiltration of noises. The ECU (1251) and the caliper (1241) are integrated, thereby making the distance between various sensors and control devices short. Further, the frame body of the ECU (1251) incorporates an inverter module (408) driving a motor (1311) and its control device, thereby simplifying a wiring connection to the motor (1311).

## Description

### Background of the invention

### (1) Field of the invention

The present invention relates to an electro mechanical brake generating a braking force by an electric motor.

### (2) Description of related art

An electro mechanical brake is a mechanical brake generating a braking force by an electric motor. This electro mechanical brake comprises an electric circuit portion controlling an output generated by the electric motor, and a mechanism portion generating a braking force based on the output of the motor. The mechanism portion is mounted on the portion close to the wheel of a vehicle, and the electric circuit portion is mounted on the spring portion of the vehicle. That is, the mechanism portion and the electric circuit portion have been mounted on the positions physically spaced apart in the vehicle.

The inventors of the present patent application have considered the possibility of integrating the mechanism portion and the electric circuit portion in view of improving a control accuracy of the electro mechanical brake.

The electro mechanical brake of a structure integrating the mechanism portion and the electric circuit portion is, for example, disclosed in JP-A-2003-137081.

### Brief summary of the invention

A conventional electric brake system is configured with a caliper and an ECU controlling the caliper provided separately, and these elements are connected by a harness. The caliper is in the same environment as parts around the wheel such as tires and wheels, and the ECU is arranged inside a compartment.

Further, the harness connecting these components is composed of a signal line controlling the caliper and a power supply line driving a motor inside the caliper, and a number of such harnesses exist. Hence, a wiring layout of the harness becomes difficult, and this leads to interference with parts around the wheel comprised of many parts. Moreover, to avoid such interference, when a bending or a twisting is applied on the harness, an excessive stress is applied on a conductive wire, and a problem such as breaking of wire is caused.

Further, when the caliper and the ECU are separated, interposition of the harness between inverters driving a motor existing inside the caliper and a motor existing inside the ECU causes a voltage drop due to resistance element of the harness when a motor driving voltage is applied from the ECU, so that the voltage to drive the motor is not applied, and this leads to the possibility of deactivating a function as a caliper.

Further, to comprise the harness involves a risk of infiltration of noises such as a radio noise from the harness, and with respect to a sensor signal line, the infiltration of the radio noise causes a malfunction of the system and this is feared to invite a significant impact. As a treatment not to be affected by this radio noise, an application of heavy shield on the harness or the like can be considered.

These problems emerge prominently as the harness becomes longer, and higher the number of harness is, greater the possible occurrence of these problems is, and a mechanical brake destined to maintain reliability is required to enhance motor control accuracy.

Hence, the present invention is required to reduce the number of harnesses, suppress a voltage drop to drive the motor, and perform a motor control considering the voltage fluctuation. Further, in order to prevent a malfunction of the brake system, it is necessary to secure noise resistance of the sensor signal.

The present invention integrates the ECU and the caliper so as to shorten the distance between various sensors and the control device. Further, inside the frame body of the ECU, an inverter module to drive the motor and its control device are incorporated, thereby to simplify a wiring connection to the motor.

The present invention can configure a system having noise resistance, and moreover, has no drop of the voltage to drive the motor, that is, can enhance a control accuracy of the motor inside the caliper.

Further, by reducing the harnesses, occurrence of troubles due to breaking of wire and the like of the harness can be reduced, and the weight of the electro mechanical brake itself can be reduced. In addition, the possibility of interference with other parts by the harness can be reduced.

Other objects, features and advantages of the invention will become apparent from the following description of the embodiments of the invention taken in conjunction with the accompanying drawings.

### Brief description of the several views of the drawing

Fig. 1 is a control block diagram of an electro mechanical brake;
Fig. 2 is a schematic diagram of a brake system of a vehicle mounting the electro mechanical brake;
Fig. 3 is a conceptual illustration of the electro mechanical brake shown in Fig. 2;
Fig. 4 is a cross-section of a specific inner structure of the electro mechanical brake shown in Fig. 2;
Fig. 5 is a circuit block diagram of the electro mechanical brake shown in Fig. 2;
Fig. 6 is a wiring block diagram of the electro mechanical brake shown in fig. 2;
Fig. 7 is a state transition view of the electro mechanical brake shown in Fig. 1;
Fig. 8 is a view showing a signal flowchart with the electro mechanical brake of Fig. 2 and a higher level control circuit at the vehicle side;
Fig. 9 is an exploded perspective view of an electric circuit portion of the electro mechanical brake of Fig. 2;
Figs. 10A and B are views showing the configuration of an outer case provided in the electro mechanical brake;
Figs. 11A and B are views showing the configuration of an inner case provided in the electro mechanical brake;
Figs. 12A-D are views showing a process in which electronic parts are mounted in the inner case and the outer case is fitted;
Figs. 13A-D are views showing a process in which the inner case is mounted with a control circuit board and the like;
Fig. 14 is a view showing a configuration of the harness connected to the electro mechanical brake;
Figs. 15A-E are views showing a process in which the inner case engaged with the outer case is fitted to a harness;
Figs. 16A and B are views showing a configuration of the I/F module provided in the electro mechanical brake;
Figs. 17A-C are views showing a state in which the I/F module is fitted to the mechanism portion in the electro mechanical brake; and
Figs. 18A-1 are views showing an electrical connection in each portion when the I/F module is fitted to the mechanism portion in the electro mechanical brake.

### Detailed description of the invention

An embodiment of an electro mechanical brake according to the present invention will be described below with reference to the drawings.

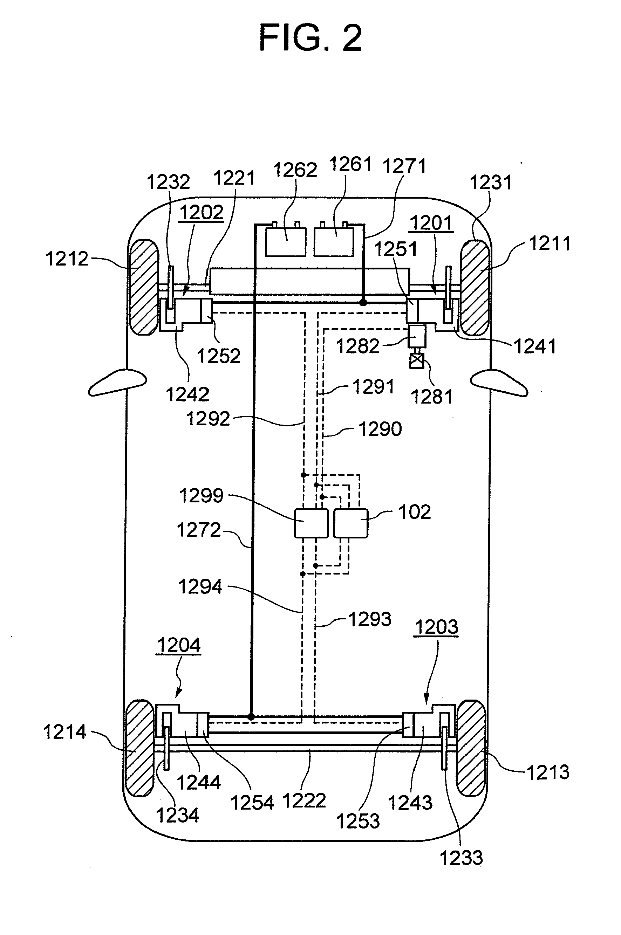

Fig. 2 is a schematic block diagram of a brake system of a vehicle mounting the electro mechanical brake comprised of one embodiment of the present invention. And, in the figure, a description of a driving mechanism for propulsion will be omitted.

A first electro mechanical brake 1201 is mounted close to a wheel shaft 1221 at a front wheel 1211 side of the right side. A second electro mechanical brake 1202 is mounted close to a wheel shaft 1221 at a front wheel 1212 side of the left side. A third electro mechanical brake 1203 is mounted close to a wheel shaft 1222 at a rear wheel 1213 side of the right side, and a fourth mechanical brake 1204 is mounted close to a wheel shaft 1222 at a rear wheel 1214 side of the left side.

While the basic structure of each of the electro mechanical brakes 1201 to 1204 is the same, the first electro mechanical brake 1201 and the second electro mechanical brake 1202 corresponding to the front wheel side are preferably configured to generate braking forces larger than those of the third mechanical brake 1203 and the fourth mechanical brake 1204 corresponding to the rear wheel side.

The wheel shaft 1221 of the front wheel and the wheel shaft 1222 of the rear wheel are provided with disc rotors 1231 to 1234 which are fixed to respective wheel shafts. Although not illustrated in Fig. 2, mechanism portions 1241 to 1244 of each of the electro mechanical brakes comprise a pair of brake pads opposed to each surface side of the disc rotors 1231 to 1234. Further, the electric motors provided for the mechanism portions 1241 to 1244 generate a running torque, and based on this running torques, the brake pads hold and press each of the disc rotors 1231 to 1234, thereby to generate a braking force.

In each of the electro mechanical brakes 1201 to 1204, the electric circuit portions 1251 to 1254 controlling the current to drive each electric motor are made into a so-called integral structure fixed to respective mechanism portions 1241 top 1244. The electric circuit portions 1251 to 1254 are fitted to the surface opposite the brake pads provided for the mechanism portions 1241 to 1244 in a wheel shaft direction.

The first electro mechanical brake 1201 and the second electro mechanical brake 1202 of the front wheel sides are supplied with an electric power from a first battery 1261 through a first power supply line 1271. The third electro mechanical brake 1203 and the fourth electro mechanical brake 1204 of the rear wheel sides are supplied with an electric power from a second battery 1262 through a second power supply line 1272.

Now, the first electro mechanical brake 1201 of the right front wheel and the fourth electro mechanical brake 1204 of the left rear wheel may be supplied with a power from the first battery 1261, and the second electro mechanical brake 1202 of the left front wheel and the third electro mechanical brake 1203 of the right rear wheel may be supplied with a power from the second battery 1262. By making the power supply line into two systems, even when malfunction occurs on one power supply line, braking by the other power supply line can be performed, so that safety is improved.

In the brake system of the vehicle shown in Fig. 2, information regarding a stroke or a force on pedal of a brake pedal 1281 is detected by a pedal operating amount detector 1282, and is inputted to a control circuit 1299 through a data signal line 1290. The control circuit 1299 is, for example, arranged inside a compartment, and performs a higher level control processing for the electric circuit portion of each electro mechanical brake as a brake system (hereinafter, referred to as "higher level control circuit").

The higher level control circuit 1299 receives a state of the first to fourth electro mechanical brakes 1201 to 1204, for example, information on a current value of a pressing force, an operating mode current value, and the like from the first to fourth electro mechanical brakes 1201 to 1204 respectively through data signal lines 1291 to 1294. Further, while monitoring a state of the electric motor, the higher control circuit 1299 transmits a control signal corresponding to the information regarding a stroke or a force on the brake pedal 1281 to each of the electro mechanical brakes 1201 to 1204 through the data signal lines 1291 to 1294, and controls each of the electro mechanical brakes 1201 to 1204.

As described above, the electro mechanical brake receives a brake command to be generated as an electric signal, and can control a brake force according to the signal change. This electric signal can be realized in whichever form it is such as an analogue signal and a communicable signal.

Incidentally, the higher level control circuit 1299 independently controls each of the electro mechanical brakes 1201 to 1204 respectively, and may control each group by making the first electro mechanical brake 1201 and the second electro mechanical brake 1202 of the front wheel sides into a group, and making the third electro mechanical brake 1203 and the fourth electro mechanical brake 1204 of the rear wheel sides into another group, or may control each group by making the first electric brake 1201 of the front wheel side and the fourth electro mechanical brake 1204 of the rear wheel side into a group and making the second electro mechanical brake 1202 of the front wheel side and the third electro mechanical brake 1203 of the rear wheel side into another group. By performing a grouping control, the effect of improving a control response, a reduction in the processing load of the control circuit, and an increase in the processing capability of fail-safe can be obtained.

The electro mechanical brakes 1201 to 1204 of the automobile configured in this manner can be directly attached on a vehicle body without intermediary, for example, such as a suspension, and this makes them liable to be affected by vibration, and moreover, are used under the environment where water is liable to infiltrate into the interior by traveling in the rain.

Further, the electro mechanical brakes 1201 to 1204 in the present embodiment, as described above, are configured by the integration of the electric circuit portions 1251 to 1254 including the control circuit in the mechanism portions 1241 to 1244, and the control circuit inside the electric circuit portion is provided with numbers of semiconductor devices. Since the semiconductor device has a nature of being changed in the characteristic by heat, the need arises to suppress a transmission to the electric circuit portions 1251 to 1254 of a high frictional heat generated by pressing the brake pads inside the mechanism portions 1241 to 1244 to the disc rotors 1231 to 1232 rotating together with the wheels, and further, the heat generated by the semiconductor device itself is also required to be efficiently diffused.

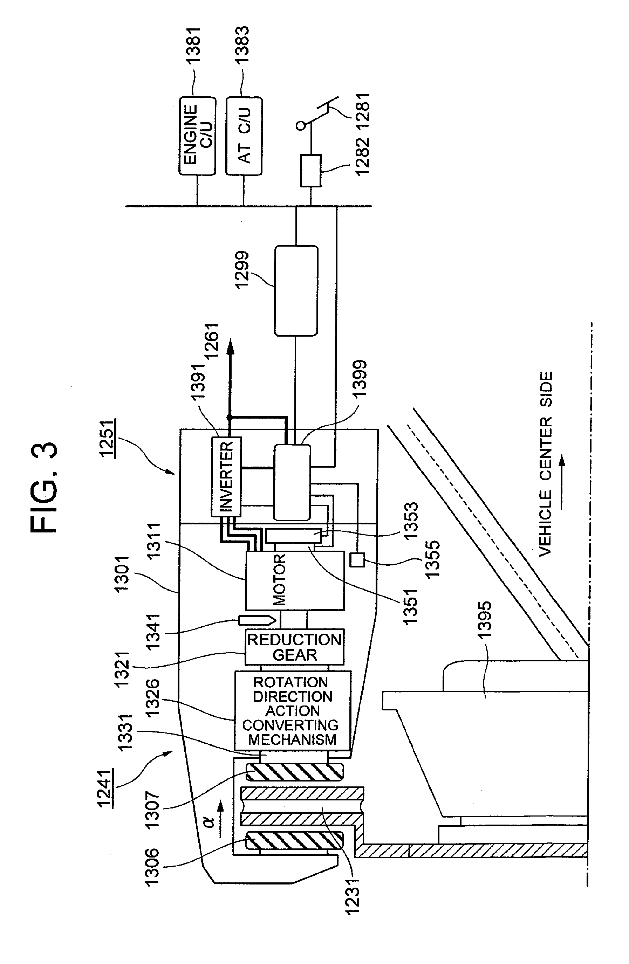

Fig. 3 shows a conceptual illustration of the electro mechanical brake of Fig. 2. The electro mechanical brake will be described below with the first electro mechanical brake 1201 as a typical example.

The electric brake 1201 comprises a pair of brake pads 1306 and 1307 arranged opposed to each other. A part of the disc rotor 1231 rotated accompanied with the rotation of the wheel shaft is arranged between each of the brake pads 1306 and 1307.

The electro mechanical brake 1201 is configured by a mutual integration of the mechanism portion 1241 and the electric circuit portion 1251. The mechanism portion 1241 and the electric circuit portion 1251 are in separated areas, and therefore, the mechanism portion 1241 and the electric circuit portion 1251 can be also structurally separated.

The mechanism portion 1241 includes in the frame body 1301, for example, an electric motor 1311 comprised of a three-phase motor, a reduction gear 1321 slowing down the rotation of the electric motor 1311, and a rotation direct action converting mechanism 1326 allowing the piston 1331 to make a reciprocating motion by converting a rotary motion of the electric motor 1311 reduced in speed by the reduction gear 1321 into a linear motion.

The brake pad 1307 is fitted to the piston 1331, and presses the disc rotor 1231 from one surfaced side by a thrust force of the piston 1331. At this time, with a pressing force from one surface side of the disc rotor 1231 taken as a reaction force, the electro mechanical brake 1201 moves in a direction to an arrow mark α in the figure, so that the brake pad 1306 presses the disc rotor 1231 from the other surface side.

The mechanism portion 1241 includes a parking brake (PKB) mechanism 1341. The parking brake mechanism 1341 stops the rotation of the electric motor 1311 in a state of supplying a thrust force to the disc rotor 1231 by the piston 1331, so that, without supplying the electric power to the electric motor 1311, a braking force can be maintained.

Close to the electric motor 1311, a rotate angle sensor 1351 detecting a rotation angle of the electric motor 1311, a pressure sensor 1353 detecting a thrust generated by the driving of the electric motor 1311, and a thermal sensor 1355 detecting the temperature of the electric motor 1311 are arranged. The output signals of the rotate angle sensor 1351, the pressure sensor 1353, and the thermal sensor 1355 are outputted to a lower level control circuit 1399 arranged inside the electric circuit portion 1251.

The electric circuit portion 1251 receives a power supply from the battery 1261 arranged at the vehicle body side. Further, through a LAN (Local Area Network) connected with an engine control unit 1381, an automatic transmission control unit 1838, a pedal operation amount detector 1282, and the like or through the higher level control circuit 1299 from the LAN, various control signals are obtained.

The electric circuit portion 1251 includes an inverter circuit 1391 and the lower level control device 1399. The inverter circuit 1391 is a circuit to control the voltage applied to the electric motor 1311. The lower level control device 1399 obtains a control signal through the LAN, and further obtains an output information signal on the rotate angle sensor 1351 from the mechanism portion 1241 side, the pressure sensor 1353, and the thermal sensor 1355 and the like, and based on these signals, controls the inverter circuit 1391.

The electric motor 1311 obtains an output from the inverter circuit 1391, and generates a running torque so as to allow the piston 1331 to generate a thrust force. Incidentally, reference numeral 1395 in the figure denotes a structural object at the vehicle side.

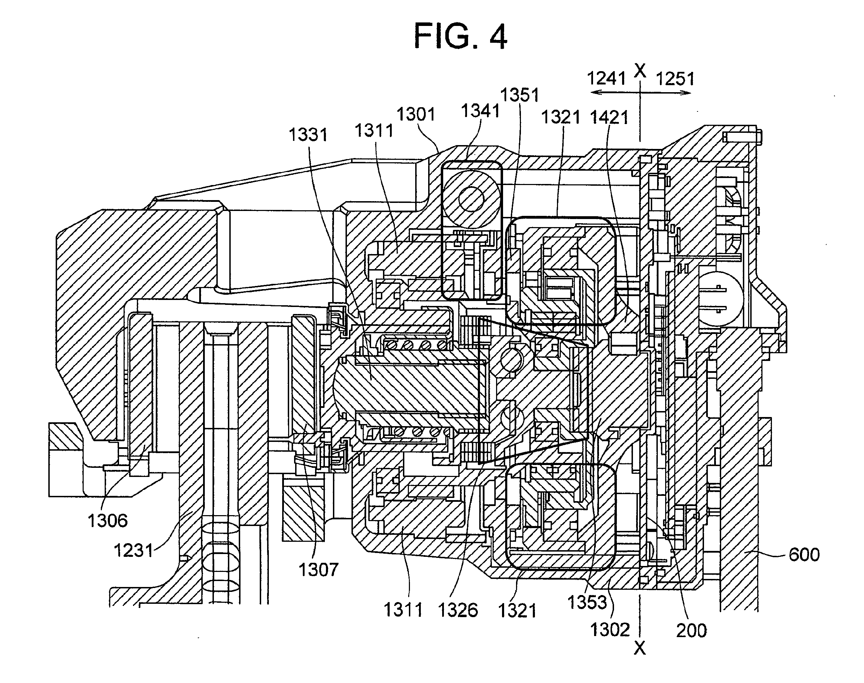

Fig. 4 shows a cross-sectional view of a specific inner structure of the electro mechanical brake of Fig. 3.

A line portion X-X in Fig. 4 shows a boundary between the mechanism portion 1241 and the electric circuit portion 1251, and the left side of the line portion X-X in the figure shows the mechanism portion 1241 and the right side in the figure shows the electric circuit portion 1251.

The inside of a bold line frame 1341 is equivalent to the parking brake mechanism 1341 shown in Fig. 3, and the inside of a bold line frame 1321 is equivalent to the reduction gear 1321 shown in Fig. 3, and the inside of a bold line frame 1326 is equivalent to the rotation direction action converting mechanism 1326. In Fig. 4, the portions of the same reference numerals as the reference numerals attached in Fig. 3 show the same members shown in Fig. 3.

The electric motor 1311 is a brush-less three-phase motor, and includes a stator fixed to the frame body 1301 and a rotor arranged inside this stator.

The electric motor 1311 operates so as to allow the rotor to rotate by a desired angle with a desired torque in accordance with a command from the upper level control device 1299. The rotation angle of the rotor is detected by the rotate angle sensor 1351. The rotate angle sensor 1351 is arranged between the reduction gear 1321 and the electric motor 1311.

The reduction gear 1321 reduces the rotation of the electric motor 1311, and increases a torque of the electric motor 1311. Hence, the electric motor 1311 can use a small type one.

A thrust plate 1421 is arranged at the electric circuit portion 1251 side inside the mechanism portion 1241, has the function of receiving the thrust of the piston 1331 as a reaction force. The pressure sensor 1353 is arranged at the center portion of the thrust plate 1241. This pressure sensor 1353, for example, is configured by a semiconductor device, and is adapted to detect the pressing forces of the brake pads 1306 and 1307 through the thrust plate 1241.

Incidentally, the inner parts of the electro mechanical brake from the brake pad 1307 to the electric circuit portion 1251 are arranged in the order of the piston 1331, the rotation direct action converting mechanism 1326, and the thrust sensor 1353 in the direction from the brake pad 1306 to the brake pad 1307.

As a result, the pressure sensor 1353 weak for a high heat can be largely spaced apart in distance from friction portions of the brake pad 1307 and the disc rotor 1231 which are heat sources. Further, a communication line electrically connecting a control board inside the electric circuit portion 1251 and the pressure sensor 1353 can be shorten to a large extent, and this makes a noise from other equipment such as the electric motor 1311 hard to mix up, thereby enhancing controllability much more. That is, the pressure sensor 1353, by being arranged at the above described position, is sufficiently applied with the heat countermeasure and the noise countermeasure.

Further, the thrust plate 1421 is arranged at a place slightly secluded toward the brake pad portion side relative to the end surface (line portion X-X in the figure) of the frame body 1301 of the mechanism portion 1241. Between the component members of the mechanism portion 1241 except for the frame body 1301 and the electric circuit portion 1251, a gap (space) is formed. On the other hand, the pressure sensor 1353 slightly projects to the electric circuit portion 1251 side by going over the end surface (line portion X-X in the figure) of the frame body 1301. However, an interface module (hereinafter, referred to as I/F module) 200 provided for the electric circuit portion 1251 is formed with a concaved portion so as to avoid interference with the pressure sensor 1353.

A majority of each component member of the mechanism portion 1241 including the frame body 1301 is made of metal, and therefore, conduction efficiency of the heat is high. Hence, a heat from the brake pad portion (brake pads 1306 and 1307 and the periphery thereof) is transmitted to the mechanism portion 1241 in the periphery, and is liable to be dissipated through the frame body 1301.

Further, the electric circuit portion 1251 is formed on the surface opposite the brake pad portion with the mechanism portion 1241 held in-between, and this reduces the transmission of a heat toward the electric circuit portion 1251 as much as possible. Further, between the component members of the mechanism portion 1241 and the electric circuit portion 1251, the above described gap (space) is formed, so that the conduction of heat toward the electric circuit portion 1251 from the mechanism portion 1241 is further reduced.

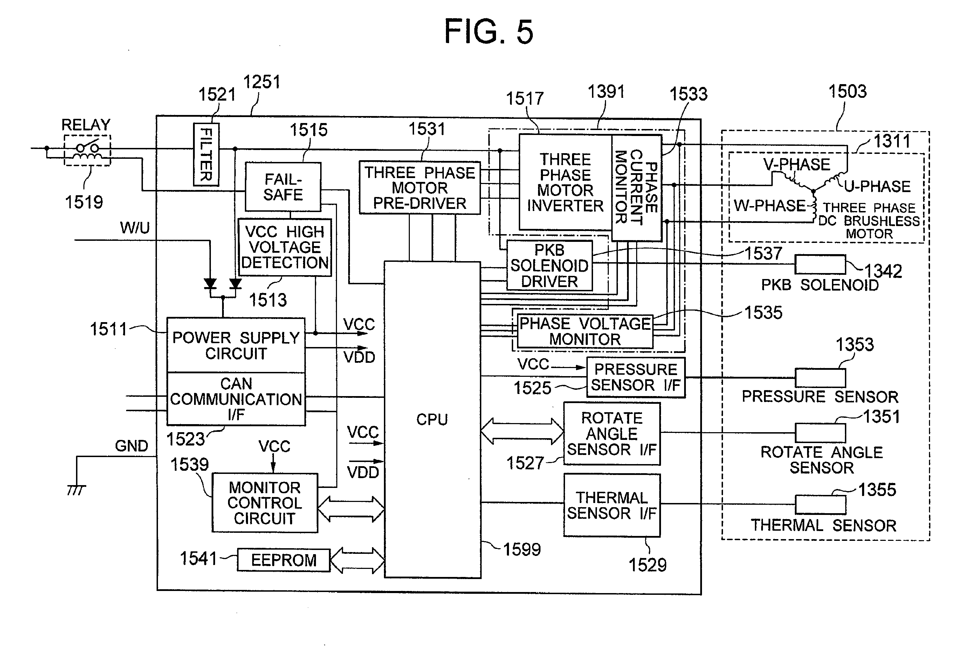

Fig. 5 shows a circuit block diagram of the electric circuit portion 1251 of Fig. 3.

A bold line frame 1251 in the figure is equivalent to the electric circuit portion 1251 shown in Fig. 3, and further, an alternate long and short dash line frame 1391 is equivalent to the inverter circuit 1391 shown in Fig. 3. In the figure, a dotted line frame 1503 is equivalent to the circuits inside the mechanism portion 1241.

Although not being illustrated, the circuits inside the mechanism portion 1241 and the electric circuit portion 1251 shown in Fig. 5 are covered by a frame body made of metal, and this protects them from causes of external damages such as flying stones. Further, by using a metal frame body with high heat transfer property, the dissipation of the heat generated by each circuit and the like can be performed. Further, by using a metal frame body with high shieldability, shielding effect for electromagnetic waves and the like are provided.

First, in the circuit of the electric circuit portion 1251, an electric power supplied through a power supply line inside the vehicle is supplied to a power supply circuit 1511. The power (Vcc and Vdd) stabilized by the power supply circuit 1511 is supplied to a central control circuit (CPU) 1599. Incidentally, the power (Vcc) from the power supply circuit 1511 is detected by a VCC high voltage detection circuit 1513. When having detected a high voltage, the VCC high voltage detection circuit 1513 allows the fail-safe circuit 1515 to operate.

The fail-safe circuit 1515 allows a relay 1519 switching the power supplied to a three-phase motor inverter circuit 1517 as hereinafter described to operate. When the high voltage is detected by the VCC high voltage detection circuit 1513, the power supply is put into an OFF state.

A filter circuit 1521 removes a noise of the power supplied inside the electric circuit portion 1251 through the relay 1519, and supplies the noise-free power to the three-phase motor inverter circuit 1517.

A central control circuit 1599 obtains a control signal from the upper level control circuit 1299 through a CAN communication interface circuit 1523, and further, obtains the output signals from the pressure sensor 1353, the rotate angle sensor 1351, and the thermal sensor 1355 arranged at the mechanism portion 1241 side through a pressure sensor interface circuit 1525, a rotate angle sensor interface circuit 1527, and a thermal sensor interface circuit 1529, respectively. The central control circuit 1599 obtains the information regarding the situation and the like at the current point of time of the electric motor 1311, and performs a feedback control based on a control signal from the higher level control circuit 1299, thereby to allow the electric motor 1311 to generate an appropriate running torque. That is, the central control circuit 1599, based on the control signal from the higher level control circuit 1299 and the detection value of each sensor, allows a three-phase motor pre-driver circuit 1531 to output an appropriate signal.

The three-phase motor inverter circuit 1517 is provided with a phase current monitor circuits 1533 and a phase voltage monitor circuit 1535. The phase current monitor circuit 1533 and the phase voltage monitor circuit 1535 monitor a phase current and a phase voltage, respectively, and output the monitoring result to the central control circuit 1599. The central control circuit 1599 allows the three-phase motor pre-driver circuit 1531 to appropriately operate in accordance with the monitoring result.

Incidentally, the three-phase motor inverter circuit 1517 incorporates a semiconductor device relatively large in output because of performing a control of the current and the voltage to drive the electric motor 1311. Hence, a high heat is generated by the operation of the semiconductor device, for which the countermeasure is taken by a configuration as hereinafter described.

Further, the central control circuit 1599, based on a control signal from the higher level control circuit 1299, a detection value of each sensor, and the like, allows a parking brake (hereinafter, referred to as PKB) solenoid 1342 inside the mechanism portion 1241 to operate through a PKB solenoid driver circuit 1537, and allows the parking brake to operate. The PKB solenoid driver circuit 1537 is supplied with a part of the power supplied to the three-phase motor inverter circuit 1517.

Further, the electric circuit portion 1251 is provided with a monitor control circuit 1539 transmitting and receiving signals to and from the central control circuit 1599 and a memory circuit 1541 comprised of an EEPROM stored, for example, with malfunction information and the like.

The electric circuit portion 1251 has a number of wire connections with the mechanism portion 1241, whereas the wiring connections with the circuits (the battery 1261 and the higher level control device 1299) other than the mechanism portion 1241 are extremely few. As a result, in the manufacturing process of the electro mechanical brake 1201 comprised of the integral structure of the mechanism portion 1241 and the electric circuit portion 1251, complicated wire connections between the mechanism portion 1241 and the electric circuit portion 1251 are performed, and after completing the electro mechanical brake 1201 and when the electro mechanical brake 1201 is fitted to the vehicle body, the wiring connections with the battery 1261 or the higher level control device 1299 can be performed in an extremely easy manner.

Incidentally, the relay 1519 is installed at a place separated from the electro mechanical brake 1241, for example, on the vehicle body upper than a chassis of the vehicle. This is because, by installing the relay 1519 on the vehicle body, infiltration of the noise into the relay 1519 is reduced, and at the same time, the whole volume of the electro mechanical brake 1241 can be made small. As a result, as shown in Fig. 5, between the relay 1519 and the filter 1521 and the fail-safe circuit 1515 inside the electro mechanical brake 1241, the need arises to perform wire connections by using a relatively long wiring, and this leads to the concern about infiltration of the noise into these wirings, and yet, as evident from the description hereafter made, the wiring is configured to be applied with the noise countermeasure.

Further, the fail-safe circuit 1515 controlling this relay 1519 is adapted to be inputted with the signal from the central control circuit 1599, for example, a control signal based on the signal from the rotate angle sensor 1351, and the fail-safe circuit 1515 is adapted to allow the relay 1519 to appropriately operate based on the control signal.

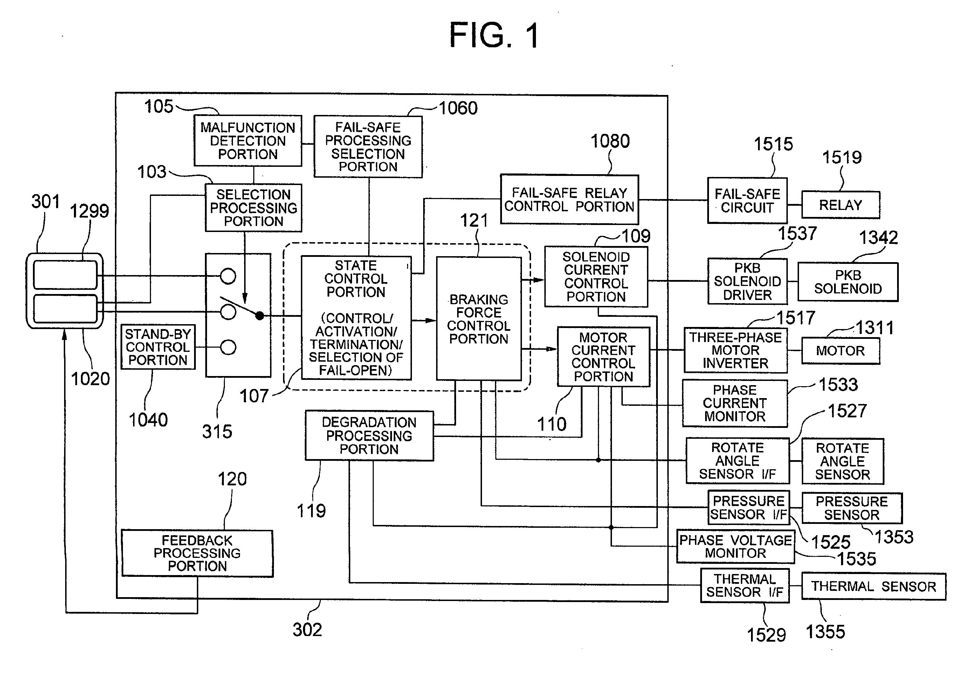

Fig. 1 is a view showing the function of the central control circuit 1599 shown in Fig. 5 by using a block diagram. In Fig. 1, to clarify the connection relationship between the central control circuit 1599 and the component members other than the circuit, some of the component members (blocks) shown in Fig. 5 are shown in duplication.

In Fig. 1, first, the higher level control device 1299 is adapted to transmit a signal to a signal selection processing portion 315. This signal is a signal corresponding to a pressing force command value and an operation mode request value, and its transmitting means, for example, is a CAN communication.

Further, the high level control device 1020 is adapted to transmit a signal to the signal selection processing portion 315. This signal is a signal corresponding to a pressing force command value and an operation mode request value, and its transmitting means, for example, is a CAN communication.

Further, the signal selection processing portion 315 is adapted to be transmitted with the signal from a stand-by control portion 1040 as hereinafter described.

The central control circuit 1599 is provided with a selection processing portion 103, and this selection processing portion 103 is adapted to receive the signal from the higher level control device 1020 and the signal from a malfunction detection portion 105 as hereinafter described. The selection processing portion 103 is adapted to respond to the reception of these signals, and transmit a signal to the signal selection processing portion 315.

The signal selection processing portion 315 is adapted to transmit one signal selected from among the signal from the higher level control device 1299, the signal from the higher level control device 1020, and the signal from the stand-by control portion 1040 to a state control portion 107 by the signal from the selection processing portion 103.

That is, when the signal from the higher level control device 1020 to the selection processing portion 103 is "High", the signal selection processing portion 315 is adapted to transmit the signal from the higher level control device 1020 to the signal selection processing means 315 to the state control portion 107, and when the signal from the higher level control device 1020 to the selection processing portion 103 is "Low", the signal selection processing portion 315 is adapted to transmit the signal from the higher level control device 1299 to the signal selection processing means 315 to the state control portion 107.

Further, when the signal from the malfunction detection portion 105 is transmitted to the selection processing portion 103 and the communication with the higher level control device 1299 is abnormal, despite of the transmission of the signal to the selection processing portion 103 from the higher level control device 1020, the signal from the higher level control device 1020 is transmitted to the state control portion 107, and when the communication with the higher level control device 1020 is abnormal, despite of the transmission of the signal to the selection processing portion 107 from the higher level control device 1020, the signal from the high level control device 1299 is adapted to be transmitted to the state control portion 107. When the communications with both the higher level control devices 1299 and 1020 are abnormal, the signal from the stand-by control portion 1040 is adapted to be transmitted to the state control portion 107.

Here, the malfunction detection portion 105 functions so as to monitor the malfunction of the electro mechanical brake 1201, and when having detected the malfunction, the malfunction detection portion 105 is adapted to transmit a signal to the selection signal processing portion 103; and at the same time, transmit a signal to a fail-safe processing portion 1060.

The fail-safe processing portion 1060 is adapted to decide a fail-safe state of the electro mechanical brake 1201 in accordance with the signal from the malfunction detection portion 105, and to transmit a signal relating to the fail-safe processing request to the state control portion 107. The fail-safe processing request in this case includes a fail-open request putting the electro mechanical brake 1201 into a fail-open state or a fail control request shifting to a control at the fail time.

The state control portion 210 has a function of switching a state in the electro mechanical brake 1201 in accordance with the signals from signal selection processing portion 315 and the fail-safe processing selection portion 1060. Here, as a state in the electro mechanical brake 1201, for example, an activation processing in progress, a pressing force control in progress, a control of pad position in progress, a control of parking brake (PKB) in progress, a fail-open in progress, a termination processing in progress, and the like can be considered.

As a result of the control by the state control portion 107, when a braking force control is performed, the state control portion 210 is adapted to transmit a signal to that effect to a braking force control portion 121. That signal to the braking force control portion 121 is a signal corresponding to the pressing force command value and a signal showing a PKB solenoid operation request from among the signals from the signal selection processing portion 315.

The braking force control portion 121 is adapted to transmit a signal corresponding to a calculation value having calculated an electric current command value to a motor current control portion 110. The braking force control portion 121 is adapted to perform a control of reducing a deviation between the pressing force command value and an actual pressing force signal in the progress of the pressing force control, and to perform a control of reducing a deviation between a positional command value of the brake pad 1306 and a position of the brake pad 1306 calculated by the rotation angle signal from the rotation angle detection sensor 1351 in the progress of the pad position control.

Further, the braking force control portion 121, when the PKB solenoid operation request is turned ON, is adapted to transmit a signal corresponding to the PKB solenoid operation request to a solenoid current control portion 109. The solenoid current control portion 109 is inputted with a signal corresponding to a voltage value of the power supply voltage on the one hand, and in accordance with this signal, is adapted to drive the PKB solenoid 1342 through the PKB solenoid driver 1537.

Further, a signal corresponding to the current command value from the braking force control portion 121 is adapted to be transmitted to the motor current control portion 110. The braking force control portion 121 is adapted to be inputted with the signal from the phase current monitor 1533, and is adapted to be controlled to reduce a deviation between the current command value and the current actually flowing in the three-phase motor inverter 1517, and to drive the electric motor 1311 through the three-phase motor inverter 1517. Here, the current control system of the electric motor 1311 includes, for example, a vector control system, a 180 degree energizing system or a 120 degree energizing system and the like.

Incidentally, in the motor current control portion 110, when a rotation angle of the electric motor 1311 is required, the rotation angle is adapted to be obtained from the signal of the rotate angle sensor 1351. In this case, when a rotation angle sensor-less control is performed, the signal from the rotate angle sensor 1351 can be made unnecessary.

The motor current control portion 110 is adapted to be transmitted with the signal from a degradation processing portion 119 as hereinafter described. This signal is a signal limiting the current in the motor current control portion 110, and, for example, is a signal equivalent to the maximum current. As a result, the motor current control portion 110 is adapted to transmit a signal to the three-phase motor inverter 1517 in the range not exceeding the limiting value.

Further, the central control circuit 1599 is provided with a degradation processing portion 119, and this degradation processing portion 119 is adapted to be inputted with a voltage signal from the phase voltage monitor 1535 and a temperature signal from the thermal sensor 1355. This degradation processing portion 119 is adapted to transmit a signal which imposes a limit on the control in the braking force control portion 121 and the control in the motor current control portion 110 based on each above described signal. As such a control, when the temperature of the electric motor 1311 by the temperature signal from the thermal sensor 1355 becomes higher than a threshold value set, for example, at 170°C, an energizing current to the electric motor 1311 is limited to 50%, so that the heat generation of the electric motor 1311 is suppressed. When the power supply voltage by a voltage signal from a VDRV voltage monitor 117 becomes lower than the threshold value set for example at 8V, the energizing current to the electric motor 1311 is limited in accordance with the power supply voltage, so that the supply voltage to the electro mechanical brake 1201 is inhibited from falling below the activation lowest voltage by the voltage drop due to harness drop.

Further, the central control circuit 1599 is provided with a fail-safe relay control portion 1080, and this fail-safe relay control portion 1080 is adapted to input a signal outputted by the state control portion 107 in accordance with its state, and in accordance with this input, is adapted to transmit a signal for switching, for example, to the fail-safe circuit 1515. As a result, the fail-safe rely control portion 1080 is adapted to control a switching off of or energizing to the relay 1519.

Further, the central control circuit 1599 is provided with a feedback processing portion 120, and this feedback processing portion 120 is adapted to output a signal corresponding to a pressing force current value, an operation mode request value, and a maximum pressing force value for the higher level control device 1299.

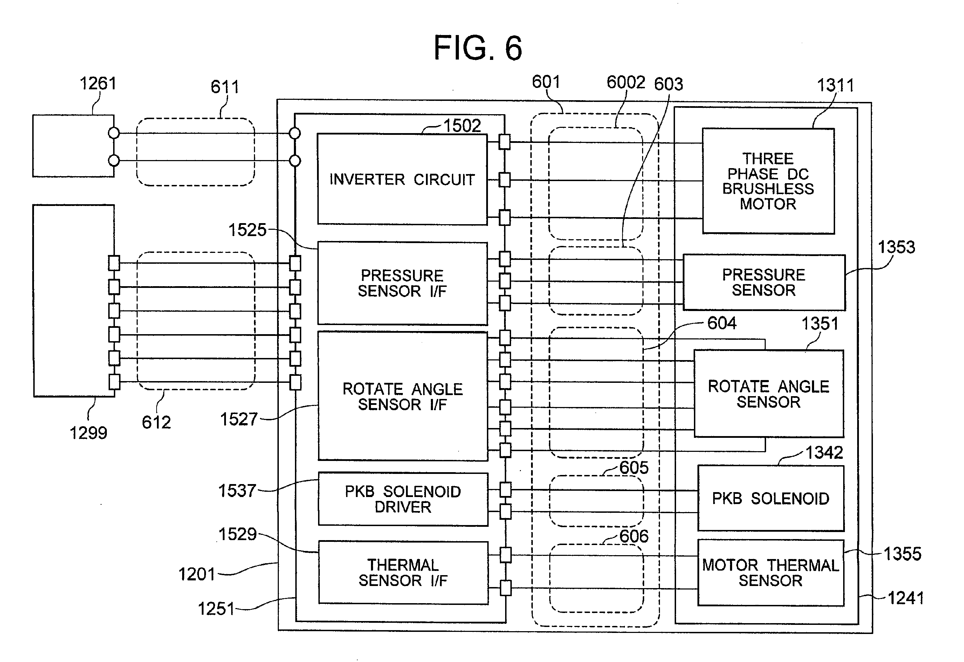

Fig. 6 is a block diagram showing a state of the wiring arranged inside the electro mechanical brake of Fig. 2. Here, a description will be made on the first electro mechanical brake 1201 taken as a representative.

In Fig. 6, an electrical connection between the circuit of the electric circuit portion 1251 and the circuit of the mechanism portion 1241 is configured by a wiring connection 601, and for example, is configured by a motor line 6002 connecting the inverter circuit 1502 and the electric motor 1311, a signal line 603 connecting the thrust sensor I/F 1525 and thrust sensor 1353, a signal line 604 connecting the rotate angle sensor I/F 1527 and the rotate angle sensor 1351, a signal line 605 connecting the PKB solenoid driver 1537 and the PKB solenoid 1341, and a signal line 606 connecting the motor thermal sensor I/F 1529 and the motor thermal sensor 1355.

Further, an electrical connection between the vehicle side and the electro mechanical brake 1201 is configured by a power supply harness 611 to connect the electric motor mechanical brake 1201 and the battery 1261, and a data signal harness 612 to connection the electro mechanical brake 1201 and the higher level control circuit 1299.

When the electro mechanical brake 1201 is configured, for example, by the mutual integration of the mechanism portion 1241 and the electric circuit portion 1251, to wine-connect the vehicle side and the electro mechanical brake 1201, the electro mechanical brake 1201 may be configured only by the power supply harness 611 and the data signal harness 612.

This is because, when compared with the case where the mechanism portion 1241 and the electric circuit portion 1251 of the electro mechanical brake 1201 are mutually independently configured, and for example, compared with the case where the electric circuit portion 1251 is configured by integrating with the higher level control circuit 1299 of the vehicle side and arranged inside the compartment, the electrical connection between the electric circuit portion 1251 and the mechanism portion 1241 can be made by a simple wiring connection structure of the power supply harness 611 and the data signal harness 612 only rather than by the wiring connection 601 comprised of the multiple line of the motor line 6002, and the signal lines 603, 604, 605, and 606, and a design degree of freedom of the vehicle side parts by improvement of bending strength due to reduction in the diameter of the wiring and suppression of the interference with the vehicle side parts is expanded, and handling improvement by reduction in the weight and reduction in the number of wiring connections can be expected.

Further, since the mechanism portion 1241 and the electric circuit portion 1251 are mutually integrated and formed, a length of the wiring connection 601 electrically connecting the mechanism portion 1241 and the electric circuit portion 1251 can be configured to be the shortest. Accordingly, the wiring connection 601 can be withheld from becoming an electric resistance to generate a voltage drop, and for example, an error between the values of the current and the voltage supplied to the electric motor 1311 by the inverter circuit 1502 and the values of the current and the voltage received by the electric motor 1311 can be suppressed. Further, with the length of the wiring connection 601 becoming short, a control having no temporal delay can be performed in transmitting the signal values by the signal lines 603, 604, 605, and 606, which exist between the electric circuit portion 1251 and the mechanism portion 1241. That is, a control of the electro mechanical brake 1201 can be made into a simplified control system, which does not take into consideration the transmission delay of the signal values and the voltage drop of the motor line 6002, so that the control accuracy of the electro mechanical brake 1201 can be increased.

Further, the wiring connection 601 is accommodated inside the electric circuit portion 1251 covered by metal, thereby to receive advantage of a shield effect for electromagnetic waves and the like by this metal. Further, the wiring connection 601, because of the shortness in length of itself, receives benefit of a further effect being hard to receive the influence of electromagnetic waves and the like. Consequently, an occurrence of malfunctions of the electro mechanical brake 1201 due to electromagnetic waves and the like can be suppressed.

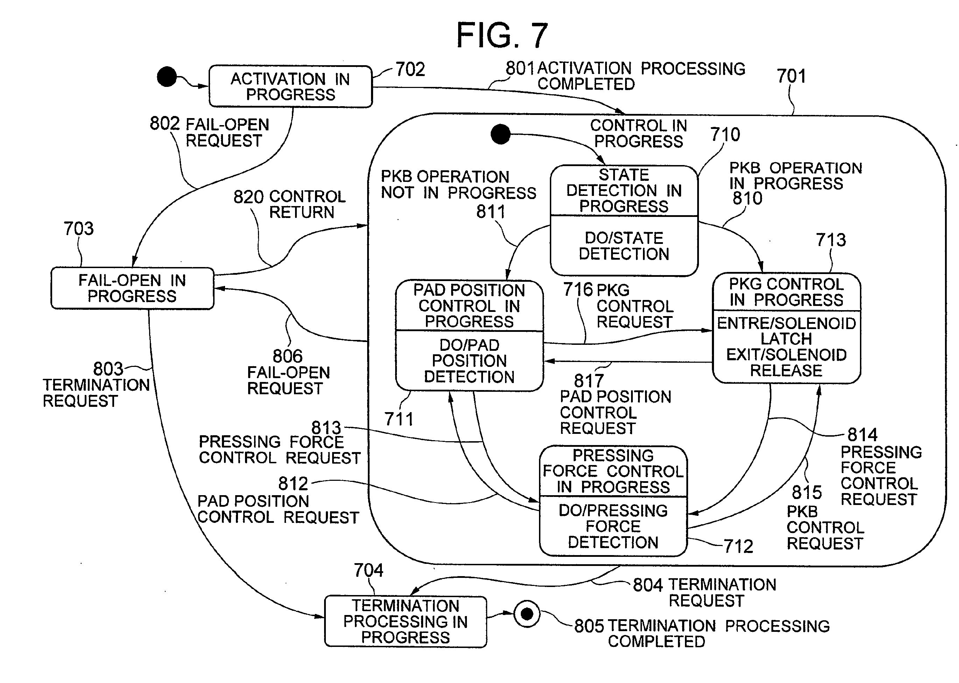

Fig. 7 is a view showing one embodiment of a state transition in the electro mechanical brake. Here, a description will be made on the first electro mechanical brake 1201 of Fig. 2 taken as a representative based on the configuration shown in Fig. 1.

The electro mechanical brake 1201, as shown in Fig. 7, broadly has a state 701 of performing a control (control state), a state 702 of performing an activation processing, a state 703 of performing an fail-open processing, and a state 704 of performing a termination processing. Further, the control state 701 is comprised of a state 710 of detecting a state of the electro mechanical brake 1201, a state 711 of performing a positional control of the brake pad 1306, a state 712 of controlling the pressing force, and a state 713 of controlling the PKB solenoid 1342.

The electro mechanical brake 1201 transits to the state 702 after activation, and performs an activation processing of the electro mechanical brake 1201. At this time, the malfunction detection portion 105 monitors a malfunction state of the electric brake 1201, and when the malfunction is detected, outputs a signal of a fail open request to the state control portion 107 through the fail-safe processing selection portion 1060, and the state 702 transits to the state 703 by a trigger 802. Further, when the activation processing normally terminates, the state control portion 107 outputs a trigger 801, and the state 702 transits to the state 701.

After the transition to the state 701, first, the state 702 transits to the state 710, and the braking force control portion 107 grasps a state of the PKB solenoid 1342 at present. When the PKB solenoid 1342 is in the progress of an operation, the state 710 transits to the state 713, and when the PKB solenoid 1342 is deactivated, the state 710 transits to the state 711.

At the state 711, the positional control of the brake pad 1306 is performed. Further, in the state 711, when a PKB control request exists in the signal from the signal selection processing portion 315, the state 711 transits to the state 713 by a trigger 716. Likewise, when a pressing force control request exists in the signal from the signal selection processing portion 315 in the state 711, the state 711 transits to the state 712 by a trigger 813.

At the state 712, the pressing force of the brake pad 1306 is controlled by feeding back the signal from the pressure sensor 1353. Further, when a pad position control request exists in the signal from the signal selection processing portion 315 in the state 712, the state 712 transits to the state 711 by a trigger 812. Likewise, when a PKB control request exists in the signal from the signal selection processing portion 315, the state 712 transits to the state 713 by a trigger 815.

At the state 713, in transition to the state 713, by generating the pressing force of the brake pad 1306 and turning on the PKB solenoid 1342, the pressing force of the brake pad 1306 is latched, and the function of the PKB solenoid 1342 is enabled. Further, when the state 713 transits to another state, the PKB solenoid 1342 is turned off and the function of the PKB solenoid is disabled. In the state 713, when a pad position control request exists in the signal from the signal selection processing portion 315, the state 713 transits to the state 711 by a trigger 817. Likewise, when a pressing force control request exists in the signal from the signal selection processing portion 315, the state 711 transits to the state 712 by a trigger 814.

In any of the states 710, 711, 712, and 713 of the state 701, when malfunctions occur and a fail-open request is generated by the signal from the fail-safe processing selection portion 1060, the state transits to the state 703 upon receipt of the trigger 806. Further, in any of the states 710, 711, 712, and 713 of the state 701, when a termination request exists in the signal from the signal selection processing portion 315, the state transits to the state 704 by the trigger 804.

At the state 703, the fail-open processing is performed so that the brake pad 1306 does not generate the pressing force. At the state 703, when the malfunction detection portion 105 determines that no malfunction factor exists and the state is normal, a normal return is generated in the signal from the fail-safe processing selection portion 1060, and the state 703 transits to the state 701 by a trigger 820. At this time, the state 703 transits to the state 710 inside the state 701. In the state 703, when a termination request exists in the signal from the signal selection processing portion 315, the state 703 transits to the state 704 by the trigger 803.

At the state 704, the control of the electro mechanical brake 1201 is terminated, and a termination processing is performed. After completing the termination processing, the state control portion 107 outputs a trigger 805 of the termination processing completion, and upon receipt of the trigger 805, the electro mechanical brake 1201 terminates.

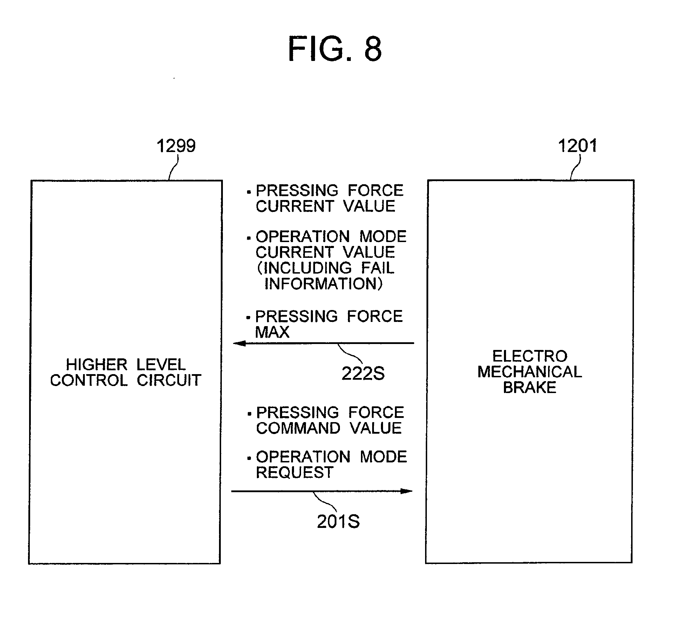

Fig. 8 is a descriptive drawing showing a mode of transmitting and receiving the signals between the electro mechanical brake and the higher level control circuit. Here, a description will be made on the case of the first electro mechanical brake 1201 of Fig. 2 taken as a representative.

The request from the higher level control circuit 1299 to the electro mechanical brake 1201 is transmitted by a signal 201S. This signal 201S is comprised of a signal requesting the electro mechanical brake 1201 to generate a pressing force when pressing the brake pad 1306 to the brake rotor 1231 and a signal designating an operation state (mode) of the electro mechanical brake 1201 such as a wake up, a control processing, a termination processing, a fail-open processing, and the like of the electro mechanical brake 1201.

Further, from the electro mechanical brake 1201 to the higher level control circuit 1299, a signal 222S by which the electro mechanical brake 1201 responds upon receipt of the request of the signal 201S is transmitted.

This signal 222S is comprised of a signal showing a force pressing the brake pad 1306 to the brake rotor 1231 by the electro mechanical brake 1201 for the signal of the pressing force command value from the higher level control device 1299 and a signal showing a state of the electro mechanical brake 1201 when an operating state (mode) of the electro mechanical brake 1201 is requested from the higher level control circuit 1299, for example, an activation processing, a control processing, a termination processing, a fail-open processing, and the like of the electro mechanical brake 1201, and a signal showing the maximum value of the pressing force generatable by the electro mechanical brake 1201 when a request is received from the signal 201.

The electro mechanical brake 1201 having received a request by the signal 201S receivers such a signal as shown in Fig. 1, and operates by the state transitions as shown in Fig. 7, and transmits a signal to the higher level control circuit 1299. With this signal grasped by the higher level control circuit 1299, each of the electro mechanical brakes 1201 to 1204 fitted to the vehicle can be controlled in a coordinate manner.

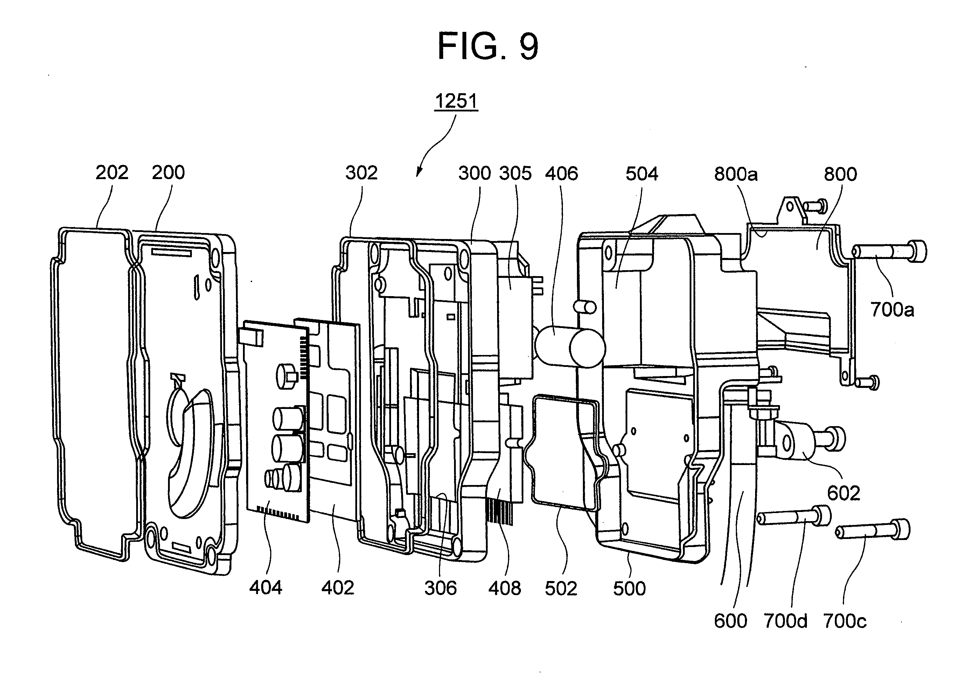

Fig. 9 is an exploded perspective view of each component member of the electric circuit portion 1251.

An I/F module 200 is a wiring board, which is fitted to the frame body of the mechanism portion 1241 and has a relay function of electrically connecting an terminal (not shown) arranged at the mechanism portion 1241 side and a terminal of the electric circuit portion 1251. As a result, the I/F module 200 has a function as a wall separating a brake portion of the mechanism portion 1241 and a control circuit portion of the electric circuit portion 1251.

Further, since the raw material of the I/F module 200 is synthetic resin, the transmission of the heat from the brake pad portion can be reduced as much as possible.

A seal 202 is arranged in the periphery of the surface of the mechanism portion 1241 side of the I/F module 200 so as to surround the center portion of the I/F module 200. The I/F module 200 is fitted to the frame body of the mechanism portion 1241 through the seal 202, and this can prevent infiltration of moistures, foreign mattes, and the like from between the mechanism portion 1241 and the I/F module 200.

An inner case 300 is fitted to the I/F module 200. Further, since the raw material of the inner case 300 is synthetic resin, the transmission of the heat from the brake pad portion can be reduced as much as possible. The inner case 300 is fitted to the I/F module 200 through the seal 302, so that infiltration of moistures, foreign matter, and the like from between the inner case 300 and the I/F module 200, can be prevented.

The inner case 300 has a function as a substrate mounting electronic parts as hereinafter described. The surface of the I/F module 200 side of the inner case 300 is mounted in order with a metal plate 402 made of aluminum and a control circuit board 404. By the metal plate 402 made of aluminum, the damages of the control circuit board 404 by twisting and the like can be avoided.

The surface where the inner case 300 and the I/F module 200 are opposed to each other is formed with a concaved portion (not shown) on a portion except for a peripheral portion including the seal 302. Inside this concaved portion, the metal plate 402 and the control circuit board 404 are arranged.

A wall portion 305 is formed so as to surround one of the regions of the surface approximately divided into two in the surface opposite to the I/F module 200 of the inner case 300. The region inside the wall portion 305 is mounted with a relatively large electronic part 406, for example, a capacitor or a reactance or the like (hereinafter, referred to as electronic part mounting region). The other region is formed with a relatively large area through hole 306 in a part of the region. Inside the through hole 306, a power module 408 is arranged.

The power module 408 has mold-converted the three-phase motor inverter circuit 118, the phase current monitor circuit 134, and the phase voltage monitor circuit 136 shown in Fig. 9.

Further, the surface opposite to the I/F module 200 of the inner case 300 is fitted with an outer case 500. The outer case 500 is provided with an opening portion 504. By this opening portion 504, the electronic part mounting region 316 of the inner case 300 can be visually observed from the outside, and operability is improved. Further, the outer case 500 is fitted so as to cover a peripheral side surface of the inner case 300, a peripheral side surface of the wall portion 305, the through hole 306, and the vicinity of the through hole 306, respectively. The outer case 500 is made of metal, for example, an aluminum alloy and the like which is applied with an anodic oxide coating on the surface, and covers a major part of the outer peripheral surface of the electric circuit portion 1251, so that the circuit is protected from the impact from the outside.

The portion which is the surface of the inner case 300 side of the outer case 500 and is opposed to the through hole 306 and the periphery of the through hole 306 is disposed with a seal 502 so as to surround the through hole 306. The seal 502 prevents moistures from infiltrating into the surface of the I/F module 200 side of the inner case 300 through the through hole 306 from the opening portion 504.

The harness 600 supplying a power or a control signal and the like from the external portion side of the electro mechanical brake is fixed to the outer case 500 by a harness stopper 602. Each wiring (not shown) inside the harness 600 is led to the electronic part mounting region 316 inside the wall portion 305 through the through holes (not shown) formed in the wall portion 305 of the inner case 300.

The I/F module 200, the inner case 300, and the outer case 500 are integrated by inserting bolts 700a and 700b (not shown), 700c, and 700d which are inserted into screw holes formed at respective four corners from the outer case 500 side, and are fitted to the mechanism portion 1241.

A cover 800 is screwed to the outer case 500 so as to cover the opening portion 504 of the outer case 500. The raw material of the cover 800 is metal, for example, an aluminum alloy.

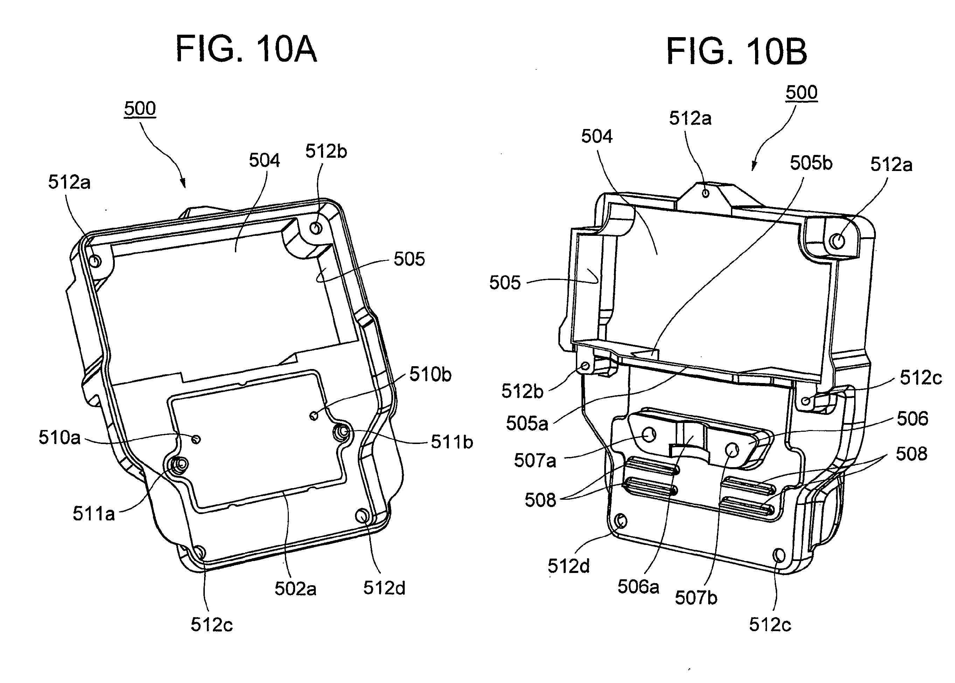

Fig. 10 is a detailed block diagram of the outer case 500. Further, Fig. 10A is an perspective view observed from the surface (inner side surface) at the side arranged in opposite to the inner case 300, and Fig. 10B is an perspective view observed from the surface (outer side surface) opposite to the side arranged facing to the inner case 300.

An outer contour of the outer case 500 is almost the same shape as the outer contour of the inner case 300. Large diameter holes 512a, 512b, 512c, and 512d are formed at respective four corners of the outer case 500. These large diameter holes are inserted with the bolts 700a, 700b, 700c, and 700d, and allow the electric circuit portion 1251 to be fixed to the mechanism portion 1241.

The surface except for the opening portion 504 of the inner side surface of the outer case 500 shown in Fig. 10A is formed with an approximately rectangular groove 502a. The groove 502a is embedded with the above described seal 502 (not shown).

Inside the region surrounded by the groove 502a, screw holes 510a and 510b to fix a power module 408 as hereinafter described are formed.

The screw holes 511a and 511b are formed so as to come close to the screw holes 510a and 510b, respectively, The groove 502a is formed so as to take a detour at the places of the screw holes 511a and 511b in order to allow the screw holes 511a and 511b to be positioned inside the area surrounded by the groove 502a. The screw holes 511a and 511b are coaxially arranged with through holes 310a and 310b as hereinafter described. Further, by the screws 320a and 320b as hereinafter described, the outer case 500 is fixed to the inner case 300.

Projections 508 shown in Fig. 10B are formed on the external surface of the outer case 500. Hence, the surface area of the outer case 500 contacting the external air increases, and heat dissipation effect can be increased.

A wall portion 505 is formed laterally to the wall portion 305 of the inner case 300 by abutting on the wall portion 305, and serves as an outer frame of the electronic part mounting region 316 together the wall portion 305 of the inner case 300. Hence, a mechanical strength of the outer frame of the electronic part mounting region 316 is improved.

A bridge 505a whose upper end surfaces are connected, is formed in the wall portion 505. Further, an opening portion 505b is formed in the bridge 505a. When the outer case 500 is incorporated into the inner case 300, a protruded wall portion 305a of the inner case 300 as hereinafter described is positioned on opening portion 505b. Further, the bridge 505a covers the peripheral side surface of the protruded wall portion 305a.

Screw holes 512a, 512b, and 512c to screw the cover 800 blocking the opening portion 504 are formed on a part of the periphery of the wall portion 505.

As shown in Fig. 10B, a harness fixing portion 506 fixing the harness 600 as hereinafter described is formed on the external side surface of the outer case 500. Further, a groove 506a is formed in the center of a protruded pedestal portion in the direction oriented to the opening portion 504 side. The harness fixing portion 506 holds and fixes the harness 600 by a harness stopper 602 as hereinafter described. Further, the harness fixing portion 506 is formed with screw holes 507a and 507b to fix the harness stopper 602 at both side of the groove 506a.

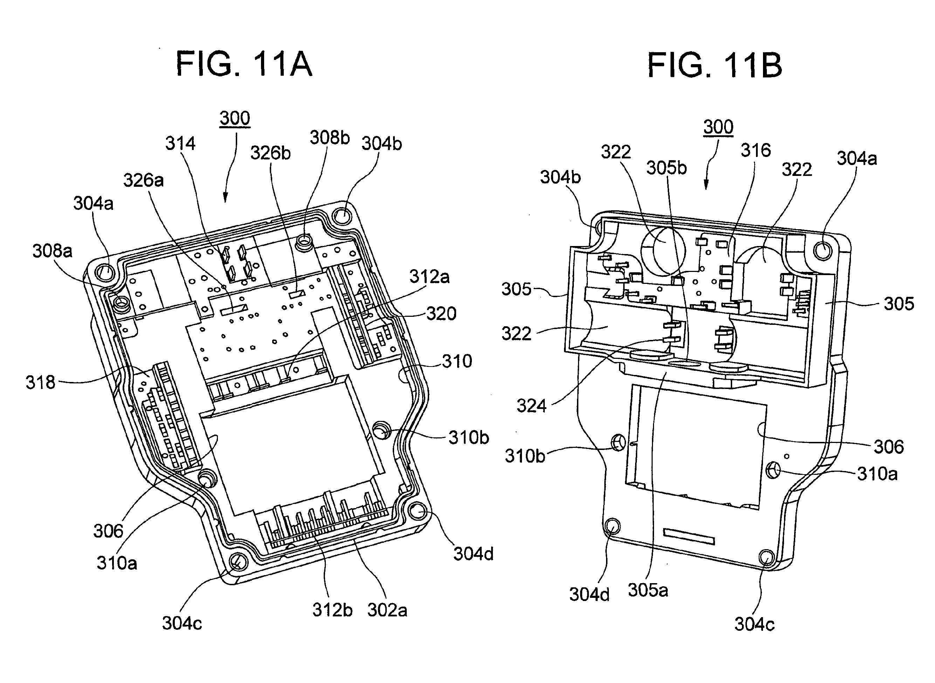

Fig. 11 is a block diagram showing one embodiment of the inner case 300. Fig. 11A is an perspective view observed from the surface (inner side surface) of the side facing the I/F module 200 of the inner case 300. Fig. 11B is an perspective view observed from the surface (outer side surface) of the side opposite to the inner side surface, in which the wiring embedded inside is also shown.

The inner case 300 has a function as a substrate mounting the electronic parts as hereinafter described. The inner case 300 is made of synthetic resin, and can suppress the transmission of the heat from the mechanism portion 1241.

As shown in Fig. 11A, the outer contour of the inner case 300 has an approximately same shape as that of the outer contour of the I/F module 200. Further, large diameter holes 304a, 304b, 304c, and 304d are formed at respective four corners of the inner case 300. By inserting bolts 700a, 700b, 700c, and 700d into the large diameter holes 304a, 304b, 304c, and 304d, the electric circuit portion 1251 including the inner case 300 are fixed to the mechanism portion 1241. Holes 308a and 308b are inserted with projections 208a and 208b formed in the I/F module 200.

The relatively large rectangular through hole 306 is formed at a position slightly shifted from the center portion of the inner case 300. A power module 408 as hereinafter described is arranged in the through hole 306.

Terminals 312a and 312b are juxtaposed on two sides in an opposite side relationship from among each periphery of the through hole 306, and are connected to an electrode (terminal) formed to protrude from the power module 408 by welding. The terminal 314 is formed on the backside of the electronic part mounting region 316. A small sized electronic part is arranged close to the terminal 314, and the electrode of this electronic part and the terminal 314 are connected.

On the periphery of the through hole 306, in the vicinity of each of the two sides in the remaining opposite side relationship except for the portion where the terminals 312a and 312b are juxtaposed, the through holes 310a and 310b are formed. The through holes 310a and 310b serve as screw holes when the outer case 500 is fixed with the inner case 300 and the power module 408.

When the inner case 300 is arranged at a fixed position by allowing the inner case 300 and the I/F module 200 to face with each other, a group of terminal holes 318 are inserted with a bifurcate terminal 210 formed in the I/F module 200, respectively, and a group of terminal hole 320 are inserted with a bifurcate terminal 212, respectively. These terminal holes incorporate the terminals abutted against the two-fork shaped portions of each of the bifurcate terminals 210 and 212.

As shown in Fig. 11B, the external side surface of the inner case 300 is provided with the through hole 306 and the electronic part mounting region 316. The electronic part mounting region 316 is formed so as to be surrounded by the wall portion 305. A concaved portion 322 formed in the electronic part mounting region 316 is mounted with the electronic parts such as a capacitor, and the shape of this concaved portion 322 is to be matched with the shape of the electronic part such as a capacitor. Close to the concaved portion 322, a terminal 324 is provided. The terminal 324 is connected to the electrode of the electronic part. Hence, each electronic part is arranged at its fixed position, and can be infallibly electrically connected to a wiring layer embedded in the inner case 300. The wiring layer embedded in the inner case 300 is comprised of a relatively small line width wiring layer (communication system bus) to perform transmission and reception of the signals and a large line width wiring layer (power system bus) supplied with a power which becomes a high voltage.

Between the peripheral portion of the inner case 300 formed with large diameter holes 304a, 304b, 304c, and 304d and the center portion slightly secluded to the inner side from peripheral portion, a step portion 310 is formed, and a concaved portion is formed in the center portion. This concaved portion is arranged with a control circuit board 404 and the like as hereinafter described, and between the inner case 300 and the I/F module 200, an air layer is formed. By this air layer, the heat transmission from the mechanism portion 1241 to the electronic parts can be suppressed.

The groove 302a is formed so as to arrange the large diameter holes 304a, 304b, 304c, and 304d at the external side and surround the center portion of the inner case 300. This groove 302a incorporates the seal 302 (not shown). Hence, moistures, foreign matters, and the like can be prevented from infiltrating the air layer between the inner case 300 and the I/F module 200.

Through holes 326a and 326b are inserted with terminals 214a and 214b formed in the I/F module 200 when the inner case 300 is arranged at a fixed position by allowing it to face the I/F module 200. The distal ends of the terminals 214a and 214b project toward the external side surface (electronic part mounting region 316) of the inner case 300 through the through holes 326a and 326b.

Further, the size of through holes 326a and 326b is formed larger than the size of the terminals 214a and 214b to be inserted. Hence, the air inside the electro mechanical brake can sufficiently convect through the through holes 326a and 326b. Consequently, a local pressure variation inside the electro mechanical brake is suppressed, and a lowering of the sealing function of the seal and the like can be suppressed (pressure adjustment function).

The protruded wall portion 305a made large in thickness of the wall portion 305 is formed on the wall portion 305 facing the through hole 306. The protruded wall portion 305a is formed with a through hole 305b so as to penetrate from the through hole 306 side to the electronic part mounting region 316 side. The protruded wall portion 305a having this thickness is fixed with a flange 606 fitted to the distal end of the harness 600 as hereinafter described, so that the distal end portion of the harness 600 is firmly fixed. Each wiring inside the harness 600 is led to the electronic part mounting region 316 through the through hole 305b.

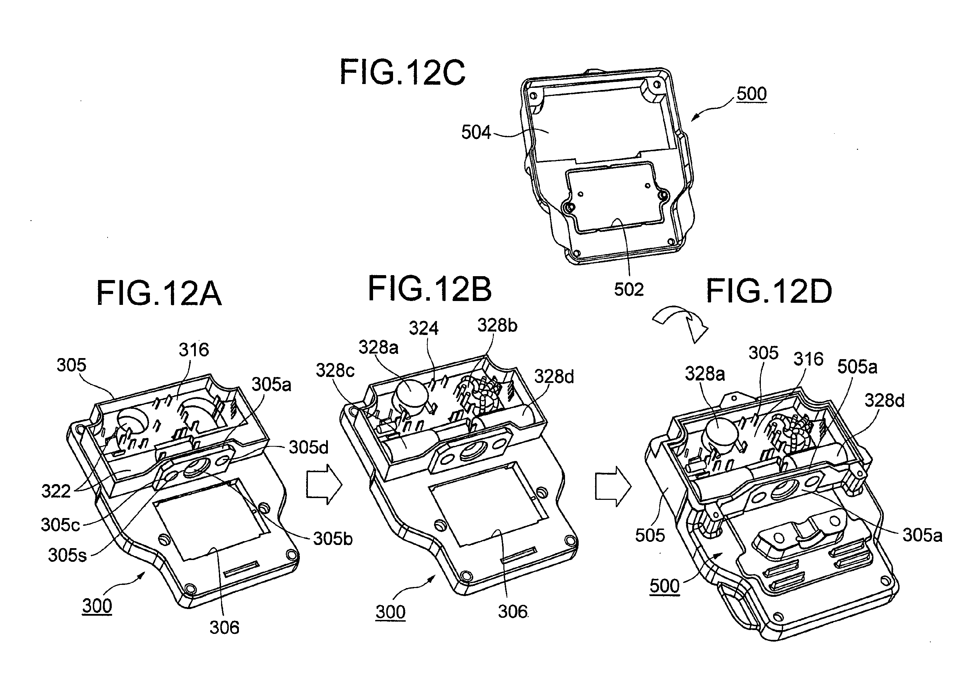

Fig. 12 is a view showing an assembly process of the outer case 500 to the inner case 300. Fig. 12A shows the inner case 300 described in Fig. 7.

The screw holes 305c and 305d to fix a flange 606 of the harness 600 are formed on both sides of the through hole 305b. Further, in the periphery of the through hole 305b, a ring-shaped seal 305S is arranged so as to surround the through hole 305b. As a result, when the flange 606 is arranged so as to abut against the protruded wall portion 305a, infiltration of moistures, foreign matters, and the like from the boundary face with the protruded wall portion 305a and the flange 606 can be prevented.

Fig. 12B shows the inner case 300 mounted with the electronic parts in the electronic part mounting region 316. The electronic parts 328a to 328d are, for example, a capacitor or a reactance and the like, and are mutually electrically connected with the terminal 324 and the like provided in the vicinity of these electronic parts 328a to 328d, for example, by welding.

Fig. 12C shows the outer case 500 described in Fig. 6.

Fig. 12D shows a state after the inner case 300 is incorporated in the outer case 500. The outer case 500, while exposing the electronic part mounting region 316 of the inner case 300 by the opening portion 504, is fitted to the inner case 300 so as to cover the other areas. That is, the wall portion 505 of the outer case 500 is arranged so as to be positioned at the external wall surface side of the wall portion 305 of the inner case 300. Further, the bridge 505a formed in the wall portion 505 of the outer case 500 is arranged so as to surround the protruded wall portion 305a of the inner case 300, and in the surface at the harness fixing portion 506 side, the surface of the protruded wall portion 305 and the surface of the wall portion 505 are substantially flush with each other.

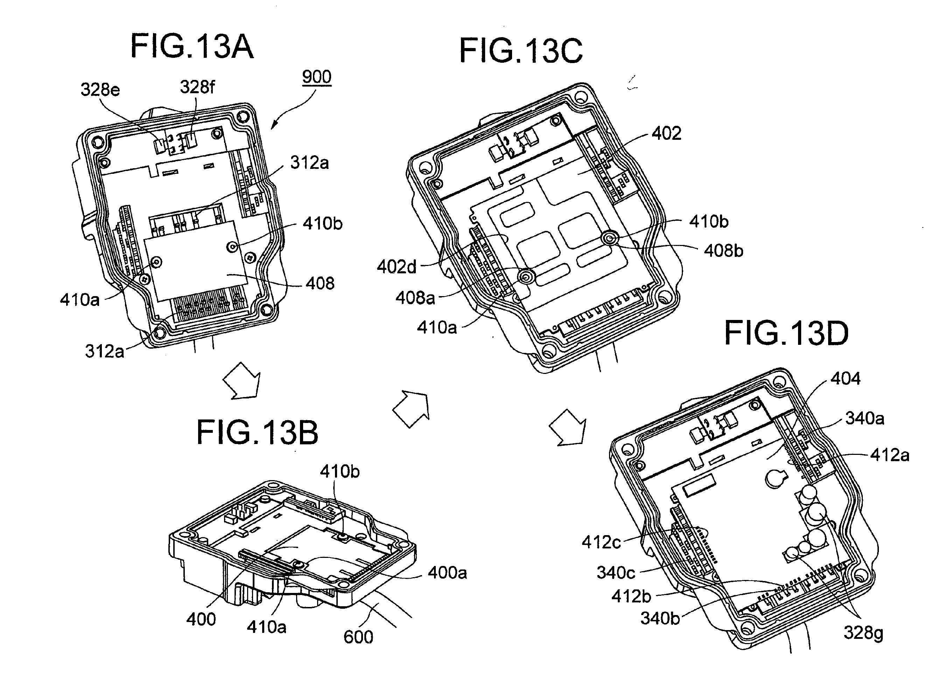

Fig. 13 is a view showing a process when the power module 408, the metal plate 402, and a control circuit board 404 are fitted to the inner case 300.

First, as shown in Fig. 13A, the inner side surface of the electronic part mounting board 900 fitted with the harness 600 as hereinafter described is mounted with electronic parts 328e and 328f relatively smaller than the electronic parts 328a to 328d. Further, the portion of the through hole 306 of the inner side surface of the electronic mounting board 900 is arranged with the power module 408. The power module 408 comprises screw holes (not shown), and screw 410a and 410b are screwed into screw holes 510a and 510b (not shown) formed on the outer case 500 through these screws holes, thereby fixing the power module 408.

Incidentally, the back side of the inner case 300 before mounting the power module 408 is formed with the through hole 306 of the inner case 300 blocked by the outer case 500 as a concaved portion, and the power module 408 is accommodated in this concaved portion. In this case, the bottom of this concaved portion is a part of the outer case 500 formed by metal, and the power module 408 is arranged so as to contact this outer case 500. Hence, the generated heat of the power module 408 is dissipated through the outer case 500, thereby improving the reliability of braking force control. Further, though not illustrated, between the outer case 500 and the power module 408, radiation grease or a heat dissipation sheet may be interposed, so that a measure may be taken to improve an efficiency of heat transfer from the power module 408 to the outer case 500.

Further, the power module 408 comprises a terminal serving as an electrode of the power module 408 at its side surface. When the power module 408 is arranged at a fixed position on the inner case 300, the terminal of the power module 408 is brought into contact with the terminals 312a and 312b of the inner case 300. The terminal of the power module 408 and the terminal of the inner case 300 are electrically connected with each other, for example, by welding. Incidentally, the distal end portions of the terminal of the power module 408 and the terminal of the inner case 300 are bent approximately 90 degrees, and the surfaces of the bent distal end portions thereof are brought into contact with each other. Hence, the welding operation from the inner side surface of the inner case 300 becomes easy, thereby improving the assembly operability.

Next, as shown in Fig. 13B, an insulation sheet 400 is arranged on the upper surface (I/F module 200 side surface) of the power module 408. As a result, an electrical insulation of each terminal portion of the power module 408 from a metal plate 402 as hereinafter described is effected. The material of the insulation sheet 400, for example, uses polyimide resin, and therefore, the connected portion between each terminal portion of the power module 408 and the metal plate 402 has a heat resistance of 150°C or more, and has insulation properties of 200 kV/mm.

Incidentally, the insulation sheet 400 extends so as to cover the terminal portion of the power module 408, and is adhered on the upper surface of the power module 408. Further, the insulation sheet 400 is formed as a pattern having a notched portion 400a which avoids the head portions of the screws 410a and 410b without covering the head portions of the screws 410a and 410b which fix the power module 408 to the outer case 500.

Next, as shown in Fig. 13C, for example, the metal plate 402 comprised of aluminum plate is arranged on the upper surface (the I/F module 200 side surface) of the insulation sheet 400. As a result, the control circuit board 404 arranged on the upper surface (the I/F module 200 side surface) of the insulation sheet 402 can be mechanically reinforced. Further, the heat generated from the control circuit board 404 can be efficiently dissipated.

Further, the metal plate 402 is sized to sufficiently cover the power module 408 and the insulation sheet 400. The through holes 408a and 408b formed on the metal plate 402 do not allow the head portions of the screws 410a and 410b for fixing to the outer case 500 of the power module 408 to be protruded from these through holes 408a and 408b, but to be exposed therefrom. As a result, the metal plate 402 can be closely brought into contact with and arranged on the insulation sheet 400, and the control circuit board 404 as hereinafter described can be closely brought into contact with and arranged on the upper surface of the metal plate 402, and this contribute to the downsizing of the electro mechanical brake.

Further, the metal plate 402 is formed with a patterned recess portion 402d in the surface opposite to the control circuit board 404 as hereinafter described. On the other hand, there may be a case where the control circuit board 404 has, for example, an inspection check terminal (not shown) exposed at the surface opposing to the metal plate 402. The recess portion 402d has the inspection check terminals formed so as to be opposed to each other in the forming region of the recess portion 402d, thereby avoiding a direct contact between the inspection check terminal and the metal plate 402. Hence, each inspection check terminal is prevented from being electrically connected to the metal plate 402, and this contributes to downsize the electro mechanical brake at the same time. Further, when allowing the control circuit board 404 to be adhered on the upper surface of the metal plate 402 by using an adhesive agent, the recess portion 402d has also an escaping function of this adhesive agent.

As shown in Fig. 13D, the control circuit board 404 is arranged on the upper surface (surface of the I/F module 200 side) of the metal plate 402. The control circuit board 404 is, for example, formed of ceramics in its board, and on its upper surface (surface opposite to the metal plate 402), a relatively large electronic part 328g is mounted. Because the board of the control circuit board 404 is made of ceramics, heat resistance and vibration resistance of the control circuit board are improved. Further, the control circuit board 404 is arranged on the upper surface of the metal plate 404, and therefore, even when a distortion occurs, for example, on the inner case 300 and the like due to some causes, for example, by an excessive reaction force from the piston 1331, the damages of the control circuit board 404 can be prevented.

The control circuit board 404 is mounted with each electronic part 414, and wiring layers 412a to 412c are embedded on the board surface or inside the board. Terminals 340a to 340c connected to these wiring layers are formed in parallel in the part of the periphery of the control circuit board 404. Between the corresponding terminals, for example, the terminal 340a and the terminal 412a are electrically connected with each other by a wire bonding comprised of aluminum.

On the side of the control circuit board 404 where the electronic parts are mounted, a gel member (not shown) is coated. As a result, the electronic part 414 and the wire bonding of the control circuit board 404 can be protected from dust, dew formation, and the like, and further, the transmission of vibrations can also be alleviated.

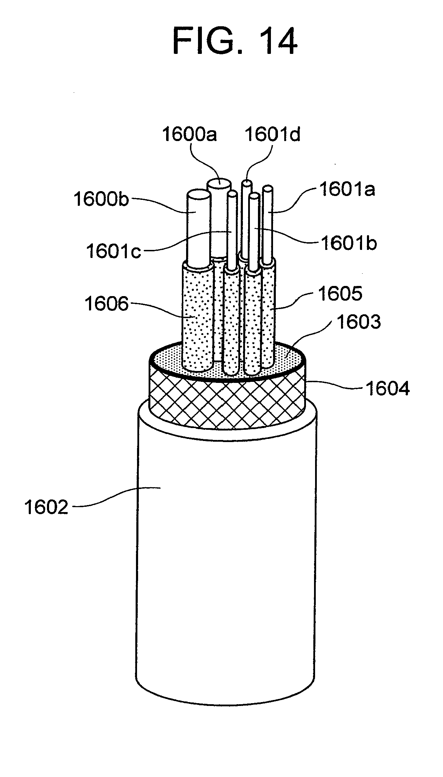

Fig. 14 is a block diagram showing one embodiment of the configuration of a harness 600 used in the present embodiment.

In Fig. 14, the power line 1600a supplies a power to operate an electric actuator mounted on the electro mechanical brake. A GND line 1600b connecting the electro mechanical brake to ground forms a pair with the power line 1600a. A power line covering member 160b covers the power line 1600a and the GND line 1600b, and protects the power line 1600a from an impact from the outside.

Communication lines 1601a to 1601d transmit a thrust command signal according to a pedal treading amount and the like of the brake pedal and an activation terminating command signal and the like of the electro mechanical brake.

A communication line covering member 1605 covers the communication lines 1601a to 1601d, and protects the communication lines from an impact from the outside. Further, by covering the communication line covering member 1605 by a shielding material, radiation of radio noises from the communication lines 1601a to 1601d may be reduced.

An air communication member 1603 is a member capable of letting the air pass through. When the air pressure difference of the air communication member 1603 exposed to both end portions of the harness 600 becomes a predetermined value or more, the air flows from the end portion of the harness 600 where the air pressure is high to the end portion of the harness 600 where the air pressure is low. Hence, the air pressure difference between both spaces connected by the harness 600 is suppressed within a predetermined range. Incidentally, as the raw material of the air communication member 1603, high molecular compound, for example, a textile material manufactured by a plant or a scientific process is suitable.

The shield member 1604 covers the external side of the air communication member 1603 to prevent the emission of the noise. The harness 600 connecting the vehicle and the electro mechanical brake is used in the circumstance such as under a spring abounding with vibrations, and moreover, is fixed with the vehicle, and therefore, is required to have severe flexural properties. By using a sheet-like matter weaving thin wires made of metal into the shield member 1604, vibration resistance and flexural properties of the harness 600 can be improved.

A covering member 1602 covers the external side of the shield member 1604, and prevents the damage of the shield member, a braking of the communication wire, and the power supply line due to the impact from the outside. The material of the covering member 1602 uses high molecular compound excellent in waterproof function and flexural properties.

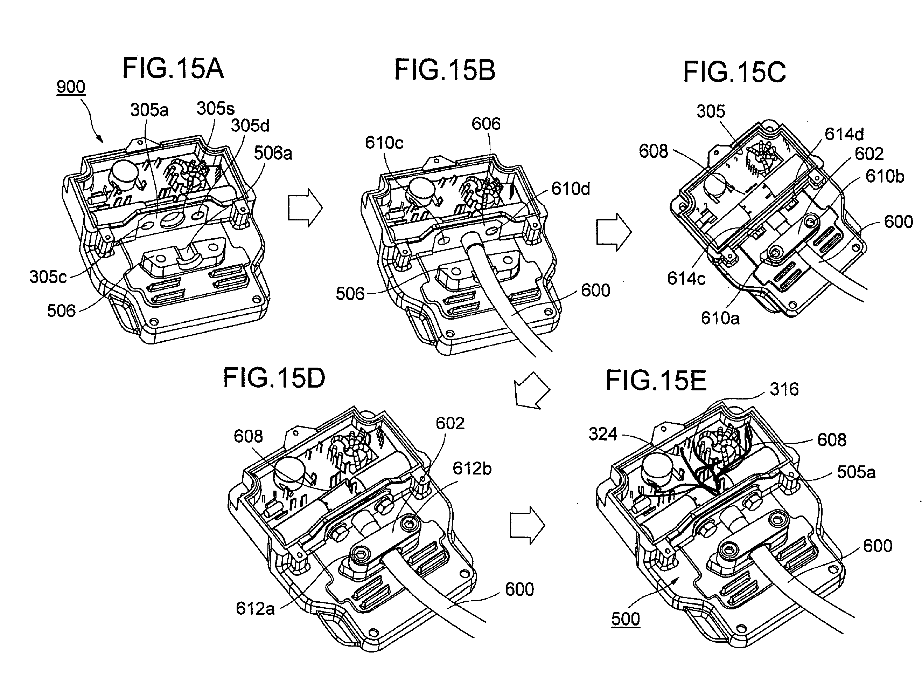

Fig. 15 is a view showing a process when the electronic part mounting board 900 described in Fig. 13 is fitted with the harness 600.

Fig. 15A shows an external side surface of the electronic part mounting board 900. This electronic part mounting board 900 is provided with a ring seal 305s so as to surround the through hole 305b in the protruded wall portion 305a formed in the inner case 300.

Fig. 15B shows the electronic part mounting board 900 in which the harness 600 is arranged at a fixed position. The flange 606 comprises a through hole (not shown) through which the harness 600 is inserted and screw holes 610c and 610d formed with this through hole held between thereof. The through hole inserted with the harness 600 is positioned to mate with the through hole 305b provided in the protruded wall portion 305a, and the screw holes 610c and 610d are positioned to mate with the screw holes 305c and 305d provided in the protruded wall portion 305a, and respective central axes are matched with each other.

Incidentally, the harness 600 is arranged inside the groove 506a of the harness fixing portion 506 at a place slightly spaced apart from the end portion of the flange 606. By this groove 506a, the movement in the direction to cross the longitudinal direction of the harness 600 is restricted.

Next, as shown in Fig. 15C, the flange 606 of the harness 600 is fixed to the protruded wall portion 305a by bolts 614c and 614d. At this time, the flange 606 of the harness 606 is adhered closely to the protruded wall portion 305a through the seal 305s. Hence, infiltration of moistures into the electronic part mounting region 316 inside the wall portion 305 through the boundary face between the protruded wall portion 305a and the flange 606 can be prevented.

Further, as shown in Fig. 15C, the harness stopper 602 is mounted above the harness fixing portion 506 so as to sandwich the harness 600.

The shape of the sandwiching portion of the harness stopper 602 is, for example, semi-cylindrical so as to match the shape of the harness 600. Further, each both end portion to sandwich the harness 600 is formed with screw holes 610a and 610b.

Next, as shown in Fig. 15D, the harness stopper 602 is fixed to the harness fixing portion 506 by bolts 612a and 612b. The bolts 612a and 612b are screwed from the screw holes 610a and 610b of the harness stopper 602 into the screw holes corresponding to the harness fixing portion 506 and fixed. Hence, the harness 600 is sandwiched between the harness fixing portion 506 and the harness stopper 602, and by the pressing force by this sandwiching, the movement in its axial direction is restricted.

Incidentally, the pulling out of the harness 600 fitted to the outer case 500 from the brake main body is extended once vertical to the direction in which the electro mechanical brake moves at braking, and after that, is extended in a direction at will. Hence, in the movement of the electro mechanical brake at braking, the running of the harness 600 can be performed so as to give always a play to the harness 600. Consequently, a breaking of wire accompanied with a tension state of the harness 600 can be prevented.

As shown in Fig. 15E, each wiring 608 pulled out from the harness 600 to the electronic part mounting region 316 is connected to each terminal 324, for example, by welding. Each terminal 324 is connected to a wiring layer provided in the inner case 300, and is protruded and formed on the surface of the electronic part mounting region 316.

Incidentally, in place of the flange 600, a connector attachable/detachable to and from the electro magnet brake may be employed. The connector at the electronic part mounting board 900 side is installed close to the electronic part mounting region 316, for example, on the wall portion 305, and is electrically connected to the electronic parts 328a to 328d inside the electronic part mounting region 316 by conductive wires and the like. The connector at the harness 600 side is engaged with the connector at the electronic part mounting board 900 side, and is electrically connected.

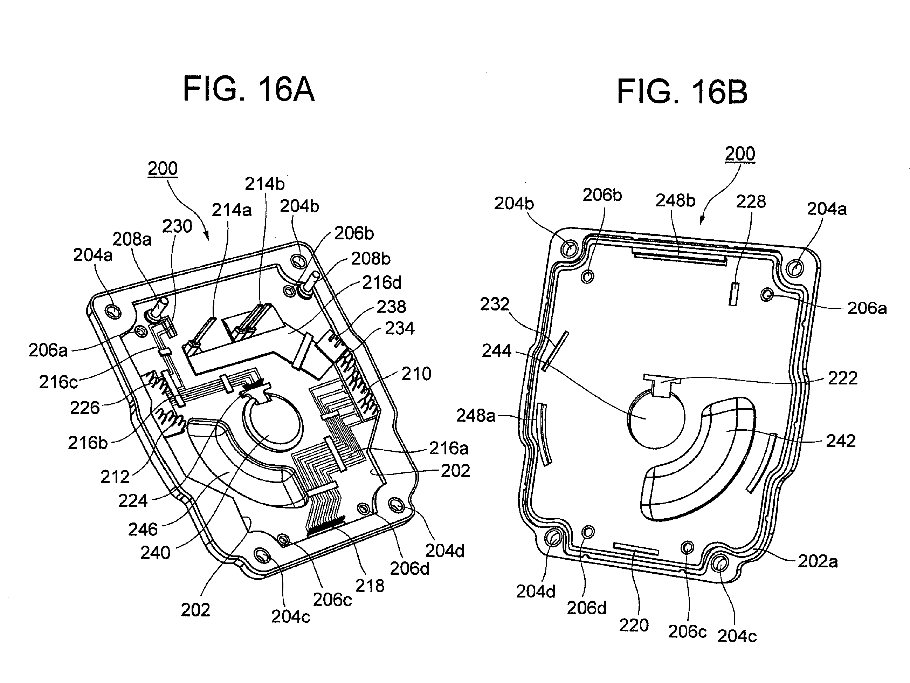

Fig. 16 shows a detailed configuration of the I/F module 200. Fig. 16A is an perspective view of the I/F module 200 observed from the surface (external side surface) opposing to the inner case 300. Fig. 16B is an perspective view observed from the surface (inner side surface) opposite to the surface shown in Fig. 16A.

The I/F module 200 has a function as a wiring circuit board having embedded wirings and terminals connected to these wirings. The material of the board covering these wirings is synthetic resin. In general, synthetic resin is small in heat conductivity, and heat transmission from the mechanism portion 1241 can be suppressed by the I/F module 200.

As shown in Fig. 16A, the thickness of the peripheral portion of the I/F module 200 is formed thicker than the thickness of the center portion except for this peripheral portion. Hence, in the portion from the outer contour of the I/F module 200 until reaching slightly inward, a step portion 202 is formed.

At the four corners of the thickened peripheral portion, large diameter holes 204a to 204d are formed. The large diameter holes 204a to 204d are screw holes to fix the I/F module 200 to the mechanism portion 1241 together with the inner case 300 and the outer case 500.

Adjacent to the large diameter holes 204a to 204d and in the thinned portion of the I/F module 200, small diameter holes 206a to 206d are formed. The small diameter holes 206a to 206d are screw holes to temporarily fix the I/F module 200 to the mechanism portion 1241.

Projected pole bodies 208a and 208b are formed close to, for example, two large diameter holes 204a and 204b from among the large diameter holes 204a to 204d. The projected pole bodies 208a and 208b have a function of positioning the I/F module 200 with the inner case 300 when the inner case 300 is arranged in opposition to the I/F module 200.

Inside the I/F module 200, wiring layers 216a to 216d are embedded. The wiring layers 216a to 216d shown in Fig. 16A are shown to be seen through. The wiring layers 216a to 216d are electrically connected to the terminals 214. Incidentally, the wiring layers 216a to 216d may be formed on the surface of the I/F module 200 and may not necessarily be embedded inside the I/F module 200. In whichever case, the wiring layers 216a to 216d can be supported by the I/F module 200, and as a result, the wiring layers 216a to 216d can be sufficiently protected from the vibrations of the electro mechanical brake 1241.

A through hole 220 is inserted with a terminal 106 extended from the rotate angle sensor 1353. This terminal 106 contacts a terminal 218 provided in the I/F module 200, and is connected, for example, by welding. The terminal 218 is pulled out to an edge portion of the center right side of Fig. 16A through the wiring layer 216a, and is connected to the bifurcate terminal 210 provided in the I/F module 200.

The through hole 222 is inserted with a terminal 108 extended from the pressure sensor 1353. This terminal 108 contacts a terminal 224 provided in the I/F module 200, and is connected, for example, by soldering. The terminal 224 is pulled out to an edge portion of the center left side of Fig. 16A through the wiring layer 216b, and is connected to the bifurcate terminal 212 provided in the I/F module 200.

The through hole 228 is inserted with a terminal 324 extended from the PKB solenoid 1342. This terminal 324 contacts a terminal 230 provided in the I/F module 200, and is connected, for example, by welding. The terminal 230 is pulled out to an edge portion of the center left side of Fig. 16A through the wiring layer 216c, and is connected to the bifurcate terminal 226 provided in the I/F module 200.

The through hole 232 is inserted with a terminal 112 extended from the thermal sensor 1353. This terminal 112 contacts a terminal 234 provided in the I/F module 200, and is connected, for example, by welding. The terminal 234 is pulled out to an edge portion of the center right side of Fig. 16A through a wiring layer (not shown), and is connected to the bifurcate terminal 236 provided in the I/F module 200.

Further, the through hole 232 is inserted with a terminal 114 extended from the three-phase motor 1311. This terminal 114 contacts a terminal 238 provided in the I/F module 200, and is connected, for example, by welding. The terminal 238 is pulled out to the center portion of Fig. 16A through the wiring layer 216d, and is connected to the terminal 214a and 214b provided in the I/F module 200.

In this manner, the through holes 220, 228, 232, and the like are provided so as to accommodate electrical terminals protruded from the mechanism portion 1241 side and arranged on the I/F module 200 side, and therefore, the formation places of the through holes 220, 228, 232, and the like in the I/F module 200 are set according to (opposed to) the positions of the electrical terminals arranged in the mechanism portion 1241.

That is, the mechanism portion 1241 is provided with the cylindrical electric motor 1311 with a rotation axis vertical to the wall surface of the I/F module 200, and the rotate angle sensor 1353, the PKB solenoid 1342, the thermal sensor 1355, the terminal 114 of three-phase motor 1311, and the like are arranged at the outer periphery of the electric motor 1311, so that the through holes 220, 228, 232, and the like are formed so as to be positioned on the periphery of a circle in the I/F module 200. Incidentally, the pressure sensor 1353 is approximately arranged on the rotation axis of the electric motor 1311, so that the through hole 222 accommodating the terminal is positioned and formed approximately on the center of the circle.

On the other hand, the bifurcate terminal 210, the bifurcate terminal 212, the two-fork shaper terminal 226, and the bifurcate terminal 236 as well as the terminals 214a and 214b and the like are provided so as to be accommodated into the inner case 300 side, so that the formation places of the bifurcate terminal 210, the bifurcate terminal 212, the two-fork shaper terminal 226, and the bifurcate terminal 236 as well as the terminals 214a and 214b and the like in the I/F module 200 are set in the relationship with the electronic parts mounted in the inner case 300.

As a result, the I/F module 200 can be freely applied with the wirings inside its surface, and it is, therefore, possible to accomplish reliable electrical connections of the electric parts of the mechanism portion 1241 side and the electric parts of the inner case 300 side without constraint imposed on the arrangement places of these parts.

The line width of the wiring layer 216d are formed broad, as compared with the line width of the other wiring layers 216a to 216c. This is because the wiring layer 216d is a power system bus to supply the power, and the wiring layers 216a to 216c are communication system bus to perform transmission and reception of the signals. Even this wiring layer 216d serving as the power system bus can be configured to be supported by the I/module 200, and as a result, the wiring layer 216d can be sufficiently protected from the vibrations of the electro mechanical brake 1241.

Further, the height of the terminals 214a and 214b protruded from the I/F module 200, as compared with the height of the other terminals 218 and the like, is formed higher. This is because they are inserted into the through holes formed in the inner case 300 (shown by reference numerals 326a and 326b of Fig. 11A) and protrude up to the surface opposite to the inner case 300.

Incidentally, from among the terminals provided in the I/F module 200, all the terminals except for the bifurcate terminals are shaped in a flat plate, and their main surfaces (surface except for the side surface) having wide areas are mutually opposed, and the mutually opposed surfaces are connected. Hence, reliability of electrical connection can be obtained.

Incidentally, as shown in Fig. 16B, in the portion opposed to the pressure sensor 1353, the concaved portion 244 is formed. The depth of the concaved portion 244 is formed larger than the thickness of the I/F module 200. Hence, as shown in Fig. 16A, in its opposite surface, the concaved portion 244 is formed as a protruded portion 240. As a result, even when the pressure sensor 1353 provided in the mechanism portion 1241 side is arranged by slightly protruding from the end surface of the frame body 100a, the occurrence of interference with the I/F module 200 cab be avoided by the concaved portion 244, thereby contributing to downsize the electro mechanical brake.

The concaved portion 246 is formed circular arc with the protruded portion 240 taken as a center in the periphery of the protruded portion 240. The concaved portion 246 is a portion opposed to the electronic parts and the like mounted on the inner case 300. By this concaved portion 246, the electronic parts and the like are prevented from interfering with the I/F module 200, and the electronic parts and the like can be stored. The depth of the concaved portion 246 is formed larger than the thickness of the I/F module 200, and therefore, as shown in Fig. 16B, in its opposite surface, the concaved portion 246 is formed as a protruded portion 242.

Further, when the I/F module 200 is abutted against and arranged on the frame body 100a of the mechanism portion 1241, the projected cylindrical bodies 248a and 248b are abutted against and arranged on the inner side surface side of the frame body 100a, and play a function of positioning the I/F module 200 for the frame body 100a.

As shown in Fig. 16B, a groove 202a is formed so as to arrange the large diameter holes 204a to 204d at the outside and to surround the center portion in the peripheral portion of the surface at the side fitted to the mechanism portion 1241. The groove 202 incorporates a seal 202 (not shown). When the I/F module 200 is abutted against and arranged on the frame body 100a of the mechanism portion 1241, the seal 202 is interposed in the boundary face between the I/F module 200 and the frame body 100a, thereby enabling the infiltration of moistures, foreign matters, and the like through this boundary face to be prevented.

Incidentally, the wiring layer formed inside the surface of the I/F module 200, as can be observed in the wiring layer 216a connecting the terminal 218 and the bifurcate terminal 210, is configured by a group of wiring layers comprised of a plurality of wiring layers running in parallel. In this case, the adjacent wiring layers are designed such that the flow of the current is mutually reversed according to need. By so doing, the reduction of inductance can be attempted. Likewise, in the other group of wiring layers formed inside the surface of the I/F module 200, the similar design can be effected.

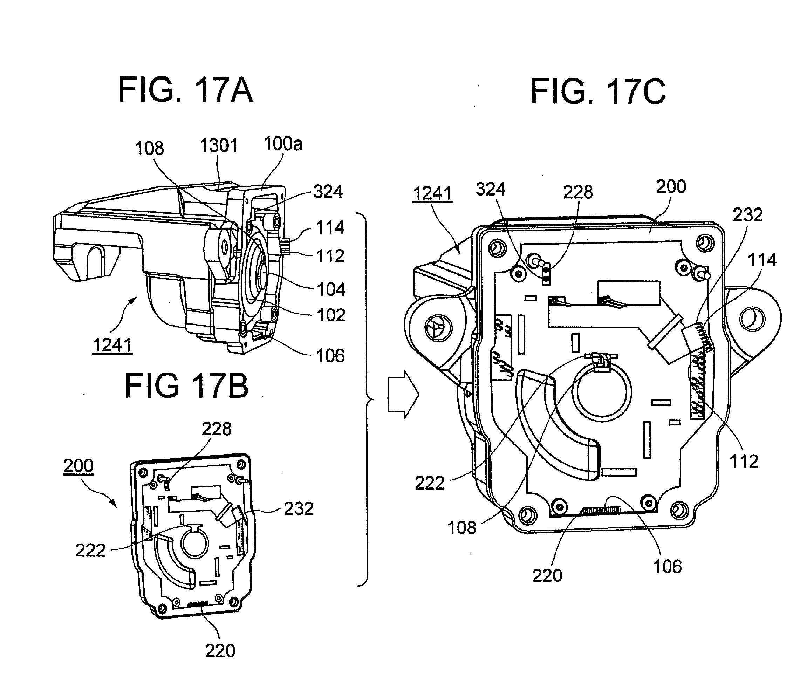

Fig. 17 is a view showing a process when the mechanism portion 1241 is fitted with the I/F module 200 described in Fig. 16. Fig. 17A is an perspective view of the mechanism portion 1241, and shows a surface fitted with the I/F module 200. Further, Fig. 17B is an perspective view of the I/F module 200, and shows the surface (surface at the side opposite to the inner case 300) opposite to the surface fitted with the mechanism portion 1241. Fig. 17C is an perspective view when the I/F module 200 is fitted to the mechanism portion 1241.

As shown in Fig. 17A, a thrust plate 102 can be visually observed on the surface side fitted with the I/F module 200 of the mechanism portion 1241 and inside the frame body 100a. The thrust plate 102 receives the reaction force due to the translational movement of the piston 1331, and at its center portion, the pressure sensor 104 is arranged. The shapes of the thrust plate 102 and the pressure sensor 104 are circular, and the shape of the frame body 100a is approximately rectangular.

The frame body 100a is formed so as to slightly protrude toward the I/F module 200 side rather than the thrust plate 102, and the thrust plate 102 is arranged at a place recessed from the end surface (surface abutting on the I/F module 200) of the frame body 100a. Hence, a gap (airspace) is formed between the thrust plate 102 (and pressure sensor 104) and the I/F module 200, and even when the heat with the brake pad as a heart source is transferred inside the mechanism portion 1241, by this gap (airspace), the heat transfer to the electric circuit portion 1251 can be suppressed.

The mechanism portion 1241 is provided with the terminals 106, 108, 112, 114 and324 in a part of the periphery of the thrust plate 102, and obtains a power or a signal from the electric circuit portion 1251. In these terminals, when observed from the side where the thrust plate 102 is visually seen, the terminal 324 for the PKB solenoid on the upper side of the figure, the three-phase terminal 114 and the thermal sensor terminal 112 in the right upper side in the figure, and the rotate angle sensor terminal 106 and the like in the lower side in the figure are arranged. Further, the terminal 108 of the pressure sensor 104 is arranged near the center portion of the thrust plate 102. Each of these terminals is a conductor in the shape of a flat-plate, and its distal end expands by sufficiently crossing over the end surface (surface abutting on the I/F module 200) of the frame body 100a. As a result, the distal end portion of each terminal is inserted through the through hole 222 formed in the I/F module 200 and is projected to the surface of the inner case 300 side of the I/F module 200.

As shown in Fig. 17C, when the I/F module 200 is fitted to the mechanism portion 1241, the terminal 324 of the PKB solenoid protrudes from the through hole 228, and the three-phase terminal 114 and the thermal sensor terminal 112 protrude from the through hole 232, and the rotate angle sensor terminal 106 protrudes from the through hole 220, and the terminal 108 of the pressure sensor 104 protrudes from the through hole 222.

Incidentally, each through hole of the I/F module 200 is formed large enough to the extent of having a sufficient gap around the terminal to be inserted therein. As a result, each through hole functions as an air pore inside the mechanism portion 1241 and inside the electric circuit portion 1251, and adjustment of the atmospheric pressure following the change of the outside air can be performed, while preventing infiltration of moistures inside the electro mechanical brake.

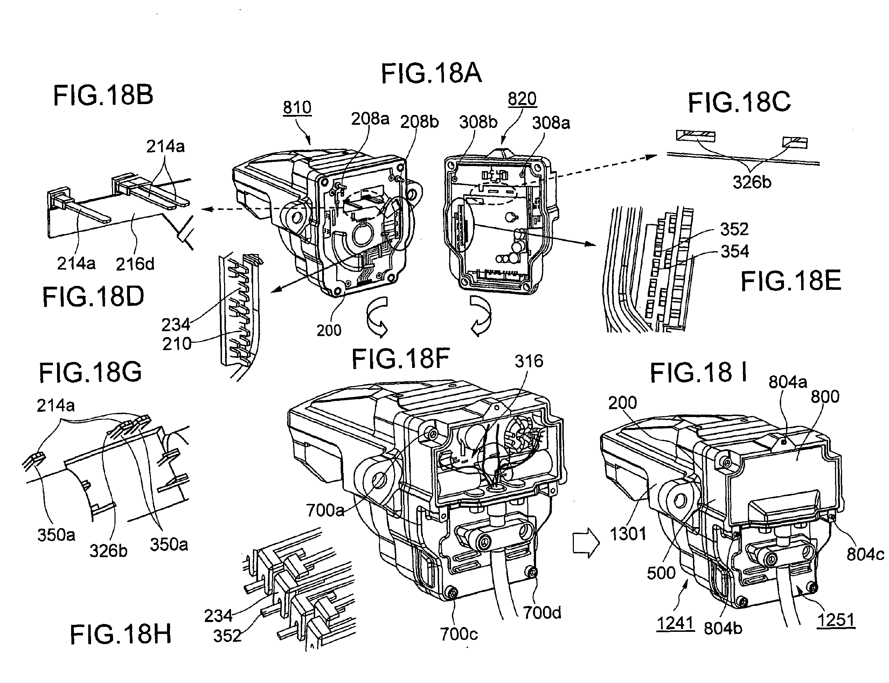

Fig. 18 is a view showing a process when the assembly 810 described in Fig. 17 and the assembly 820 described in Fig. 15 are assembled.

Fig. 18A shows each surface to be opposed to the assembly 810 and the assembly 820.

As shown in Fig. 18B, three pieces of reed shaped terminals 214a and 214b protruded relatively large are provided in the I/F module 200. Two pieces of the terminals from among three pieces of the terminals are adjacent to each other, and the remaining one piece is arranged isolated. As a result, each terminal 214a and 214b can be protruded at a predetermined place in the electronic part mounting region 316.

These three pieces of the terminals 214a and 214b are integrally formed with the wiring layer 216d embedded in the I/F module 200, and this wiring layer 216d is bent inside the I/f module 200, thereby to be protruded and formed on the surface of the I/F module 200.

As shown in Fig. 18C, the inner case 300 is formed with the through holes 326a and 326b. These through holes 326a and 326b are inserted with each terminal 214a and 214b, and is protruded to the electronic part mounting region 316 formed on the surface opposite to the inner case 300. These terminals 214a and 214b are connected with other terminals in the electronic part mounting region 316.

Further, as shown in Fig. 18D, the I/F module 200 is juxtaposed and provided with the bifurcate terminals 210 and 234. These bifurcate terminals are also integrally formed with the wiring layer embedded inside the I/F module 200, and this wiring layer is formed relatively thin as it takes charge of transmission and reception of the signals. Further, the wiring layer is formed thick in the portion reaching the bifurcate terminals 210 and 234 inside the I/F module, and at this portion, the wiring layer is bent so as to be protruded on the surface of the I/F module 200.

As shown in Fig. 18E, the inner case 300 opposed to the bifurcate terminals 210 and 234 is formed with a groove 354, and this groove 354 is inserted with each bifurcate terminal. Inside the groove 354, a terminal 352 is juxtaposed. This terminal 352 is sandwiched between each of the bifurcate portions of each of the bifurcate terminals 210 and 234, and is connected to the wiring embedded in the inner case 300.

As apparent from Figs. 18A to 18E, when the assembly 820 is assembled into the assembly 810, the terminals 214a and 214b of the I/F module 200 side can be exposed to the electronic part mounting region 316 of the inner case 300, and at the same time, the bifurcate terminal 210 and the like can be connected to the wiring inside the inner case 300 through the terminal 352.

Next, as shown in Fig. 18F, the assembly 820 is assembled into the assembly 810 with face to face contact. In this case, the projected pole bodies 208a and 208b formed to protrude to the I/F module 200 side are inserted into the holes 308a and 308b formed at the inner case 300 side, and the positioning thereof is performed. The assembly 810 and the assembly 820 are mutually firmly fixed by the bolts 700a, 700b, 700c, and the 700d which are screwed into the screw holes of the assembly 810 through the holes formed at the four corners of the assembly 820.

As shown in Fig. 18G, the terminals 214a and 214b inserted into the through holes 326a and 326b protrude inside the electronic part mounting region 316, and further, are electrically connected with each of the terminals 350a and 350b provided in the inner case 300. Consequently, at this stage, the terminals 214a and 214b, and terminals 350a and 350b are mutually electrically connected, for example, by welding.

Further, as shown in Fig. 18H, the terminal 352 of the inner case 300 side is sandwiched by the bifurcate terminal 234 at the I/F module 200 side, and is electrically connected with the bifurcate terminal 234.

As shown in Fig. 18I, the cover 800 covers the electronic part mounting region 316 which is exposed. The cover 800 is fixed to the outer case 500 by screwing screws 804a, 804b, and 804c into the screw holes formed in the outer case 500 through the screw hole formed in the cover 800.

Here, in the electro mechanical brake shown in Fig. 18I, the metal frame body of the mechanism portion 2341 is not mutually connected with the metal outer case 500 of the electric circuit portion 1251 and the cover 800, but mutually spaced apart with the I/F module 200 made of synthetic resin sandwiched between thereof. As a result, the heat generated at the mechanism 1241 side is less likely to be transmitted to the electric circuit portion 1251 side. Hence, the heat generated inside the mechanism portion 1241 is dissipated to the atmospheric air through the frame body 1301 of the mechanism portion 1241, while the heat generated inside the electric circuit portion 1251 is dissipated to the atmospheric air through the outer case 500 and the cover 800. As a result, the mechanism portion 1241 and the electric circuit portion 1251 can be made almost independent thermal-wise.

The electro mechanical brake according to the above described embodiment can be summed up as follows.

### (Note 1)

An electro mechanical brake comprising a brake portion performing a braking operation and a control circuit portion controlling the braking operation,
wherein the brake portion comprises a brake pad pressed to a disc rotor rotated together with wheels, an AC motor generating a running torque, and/or a rotate angle sensor detecting the rotate angle of the motor,
wherein the control circuit portion comprises a power module including an inverter element to convert a direct current (DC) into an alternating current (AC), and a CPU controlling the running torque of the motor by controlling the AC current supplied to the AC motor from the power module based on a control command signal received by the control circuit portion and the output of the rotate angle sensor, and/or an outside connecting portion receiving the DC current and the control command signal,
wherein the brake portion and the control circuit portion are mechanically integrally assembled so as to be an integral structure,
wherein a wall to separate the brake portion and the control circuit portion is provided in the integral structure,
wherein a signal line transmitting the output of the rotate angle sensor to the control circuit portion and a power line supplying the AC current to the AC motor are provided in the integral structure through the wall,
wherein the brake portion is covered by a metal case, and/or
wherein the control circuit portion and the outside connecting portion are covered by the metal case.

### (Note 2)

The electro mechanical brake according to note 1, wherein at least one of the signal line and the power line is supported by the wall.

### (Note 3)

The electro mechanical brake according to note 1, wherein the control circuit portion is provided on the surface opposite to the surface provided with the brake pad in the brake portion.

### (Note 4)

The electro mechanical brake according to note 3, further arranged between the rotation direct action converting mechanism and the control circuit portion, and comprising a pressure sensor to detect a pressing force of the brake pad.

### (Note 5)

The electro mechanical brake according to note 1, wherein the wall is made of synthetic resin.

### (Note 6)

An electro mechanical brake, comprising:
a braking force generating portion which includes a brake pad, an AC motor generating a running torque, a rotion direct action converting mechanism converting the running torque into the pressing force of the brake pad, a rotation angle detection sensor detecting the rotate angle of the AC motor, and/or
a control circuit portion which includes a power module comprising an inverter element converting the DC current into the AC current, a CPU controlling the AC current supplied to the AC motor from the power module based on the outputs of a control command signal and the rotate angle sensor, and/or further including a malfunction detection portion detecting a malfunction, and a relay control circuit switching power distribution and discontinuation of the DC current to the power module and controlling a relay installed in a vehicle body according to the detection result of the malfunction detection portion;
wherein the braking force generating portion and the control circuit portion are covered by a metal made frame body, and are integrally structured.

### (Note 7)

The electro mechanical brake according to note 6, further configured such that the power line transmitting the DC current to be supplied to the power module and the signal line transmitting a control signal from the relay control circuit to the relay are configured by a piece of the cable covered with the same outer coat in the portion connecting the vehicle side and the control circuit portion.

### (Note 8)

The electro mechanical brake according to note 6, further comprising a wall separating the brake generating portion and the control circuit portion,
wherein a signal line in which the output of the rotate angle sensor is transmitted to the control circuit portion and a power line supplying the AC current to the AC motor are provided in the integral structure through the wall.

### (Note 9)

The electro mechanical brake according to note 8,
wherein at least one of the signal line and the power line is supported by the wall.

### (Note 10)

The electro mechanical brake according to note 6,
wherein the control circuit portion is provided in the surface opposite the surface provided with the brake-pad in the brake generating portion.

### (Note 11)

The electro mechanical brake according to note 6,
wherein the malfunction is determined by the output value of the rotate angle sensor.

It should be further understood by those skilled in the art that although the foregoing description has been made on embodiments of the invention, the invention is not limited thereto and various changes and modifications may be made without departing from the spirit of the invention and the scope of the appended claims.

The above features and embodiments can be combined in any way partly or as whole.

## Claims

1. An electro mechanical brake (1201) comprising a brake portion (1241) performing a braking operation and a control circuit portion (1251) controlling the braking operation;
**characterizing in that** said brake portion (1241) comprises a brake pad (1306) pressed to a disc rotor (1231) rotated together with wheels (1211), an AC motor (1311) generating a running torque, and a rotate angle sensor (1351) detecting the rotate angle of said motor (1311);
said control circuit portion (1251) comprises a power module (408) including an inverter element (1391) to convert a direct current (DC) into an alternating current (AC), a CPU (1599) controlling the running torque of said motor (1311) by controlling the AC current supplied to said AC motor (1311) from said power module (408) based on a control command signal received by the control circuit portion (1251) and the output of the rotate angle sensor (1351), and an outside connecting portion receiving the DC current and the control command signal;
said brake portion (1241) and said control circuit portion (1251) are mechanically integrally assembled so as to be integrally structured;
a wall (305) to separate said brake portion (1241) and said control circuit portion (1251) is provided in said integral structure;
a signal line (604) transmitting the output of said rotate angle sensor (1351) to said control circuit portion (1251) and a power line (6002) supplying said AC current to said AC motor are provided in said integral structure through said wall (200);
said brake portion (1241) is covered by a metal case; and
said control circuit portion (1251) and said outside connecting portion are covered by a metal case.

2. The electro mechanical brake (1201) according to claim 1, **characterizing in that** at least one of said signal line (604) and said power line (6002) is supported by said wall (200).

3. The electro mechanical brake (1201) according to claim 1 or 2, **characterizing in that** said control circuit portion (1251) is provided on the surface opposite to the surface provided with said brake pad (1306) in said brake portion (1241).

4. The electro mechanical brake (1201) according to claim 3, further arranged between said rotation direct action converting mechanism (1326) and said control circuit portion (1251), and comprising a pressure sensor (1353) to detect a pressing force of said brake pad (1306).

5. The electro mechanical brake (1201) according to at least one of claims 1 to 4, **characterizing in that** said wall (200) is made of synthetic resin.

6. An electro mechanical brake (1201), comprising:
a braking force generating portion (1241) which includes a brake pad (1306), an AC motor (1311) generating a running torque, a rotation direct action converting mechanism (1326) converting said running torque into the pressing force of said brake pad (1306), a rotate angle detection sensor (1351) detecting the rotate angle of said AC motor (1311); and
a control circuit portion (1251) which includes a power module (408) comprising an inverter element (1391) converting the DC current into the AC current, a CPU (1599) controlling the AC current supplied to said AC motor (1311) from said power module (408) based on the outputs of a control command signal and said rotate angle sensor (1351) and further including a malfunction detection portion (105) detecting a malfunction, and a relay control circuit (1080) switching power distribution and discontinuation of the DC current to said power module (408) and controlling a relay installed in a vehicle body according to the detection result of said malfunction detection portion (105);
**characterizing in that** said braking force generating portion (1241)and said control circuit portion (1251) are covered by a metal made frame body, and are integrally structured.

7. The electro mechanical brake (1201) according to claim 6, further configured such that a power line (6002) transmitting the DC current to be supplied to said power module (408) and a signal line (604) transmitting a control signal from said relay control circuit (1080) to said relay are configured by a piece of the cable covered with the same outer coat in the portion connecting the vehicle side and said control circuit portion (1251).

8. The electro mechanical brake (1201) according to claim 6 or 7, further comprising a wall (200) separating said brake generating portion (1241) and said control circuit portion (1251),
**characterizing in that** the signal line (604) in which the output of said rotate angle sensor (1351) is transmitted to said control circuit portion (1251) and the power line (6002) supplying said AC current to said AC motor (1311) are integrally provided in said integral structure through said wall (200).

9. The electro mechanical brake (1201) according to at least one of claims 6 to 8, **characterizing in that** at least one of said signal line (604) and said power (6002) line is supported by said wall (200).

10. The electro mechanical brake (1201) according to at least one of claims 6 to 9, **characterizing in that** said control circuit portion (1251) is provided in the surface opposite to the surface provided with said brake pad (1306) in said brake generating portion (1241).

11. The electro mechanical brake (1201) according to at least one of claims 6 to 10, **characterizing in that** said malfunction is
determined by the output value of said rotate angle sensor (1353).
